# EUROPEAN PATENT APPLICATION

(11) **EP 4 557 004 A1**
(43) Date of publication of application: **21.05.2025**
(21) Application number: 23846107.3
(22) Date of filing: 27.06.2023
(51) Int. Cl.: G03F 7/36, G03F 7/004

(54) **METHOD FOR PROCESSING SUBSTRATE, AND SYSTEM FOR PROCESSING SUBSTRATE**

(30) Priority: 29.07.2022 US 202263393377 P
(71) Applicant: Tokyo Electron Limited, Tokyo 107-6325 (JP)
(72) Inventor: NAKANE, Yuta, Kurokawa-gun, Miyagi 981-3629 (JP); ONO, Kenta, Kurokawa-gun, Miyagi 981-3629 (JP); KUMAKURA, Sho, Kurokawa-gun, Miyagi 981-3629 (JP); NISHIZUKA, Tetsuya, Kurokawa-gun, Miyagi 981-3629 (JP); HONDA, Masanobu, Kurokawa-gun, Miyagi 981-3629 (JP)
(74) Representative: Piotrowicz, Pawel Jan Andrzej
(86) International application number: PCT/JP2023/023830
(87) International publication number: WO 2024/024373

(57) **Abstract**

A method for processing a substrate is provided. The method for processing a substrate includes (a) providing a substrate on a substrate support in a processing chamber, the substrate having an underlying film and a resist film disposed on the underlying film and formed of a metal-containing resist, and the resist film having a first region and a second region. The method for processing a substrate further includes (b) dry-developing the resist film by supplying a processing gas containing a carboxylic acid into the processing chamber, exposing the substrate to the carboxylic acid, and selectively removing the second region with respect to the first region. In the (b), a pressure or a partial pressure of the carboxylic acid is 0.3 Torr (40 Pa) or more and less than 100 Torr (13,332 Pa).

## Description

### CROSS-REFERENCE TO RELATED APPLICATIONS

This application is based on and claims the benefit of priority from U.S. Provisional Patent Application No. 63/393377, filed on July 29, 2022, the entire contents of which are incorporated herein by reference.

### Technical Field

Example embodiments of the present disclosure relate to a method for processing a substrate and a system for processing a substrate.

### Background Art

Patent Literature 1 discloses a technique for forming a thin film that is patterned using extreme ultraviolet light (hereinafter, referred to as "EUV") on a semiconductor substrate.

### Citation List

### Patent Literature

[Patent Literature 1] Japanese Unexamined Patent Publication No. 2021-523403

### Summary of Invention

### Technical Problem

The present disclosure provides a technology of appropriately dry-developing an exposed metal-containing resist.

### Solution to Problem

In an example embodiment, a method for processing a substrate is provided. The method for processing a substrate includes (a) providing a substrate on a substrate support in a processing chamber, the substrate having an underlying film and a resist film disposed on the underlying film and formed of a metal-containing resist, and the resist film having a first region and a second region. The method for processing a substrate further includes (b) dry-developing the resist film by supplying a processing gas containing a carboxylic acid into the processing chamber, exposing the substrate to the carboxylic acid, and selectively removing the second region with respect to the first region. In the (b), a pressure or a partial pressure of the carboxylic acid is 0.3 Torr (40 Pa) or more and less than 100 Torr (13,332 Pa).

### Advantageous Effects of Invention

According to an example embodiment of the present disclosure, a technology of appropriately dry-developing an exposed metal-containing resist may be provided.

### Brief Description of Drawings

FIG. 1 is a diagram for describing a configuration example of a heat treatment system.
FIG. 2 is a diagram for describing a configuration example of a plasma processing system.
FIG. 3 is a diagram for describing a configuration example of a capacitively coupled plasma processing apparatus.
FIG. 4 is a flowchart illustrating a method for processing a substrate according to a first embodiment.
FIG. 5 is a diagram illustrating an example of a cross-sectional structure of a substrate W provided in the operation ST11 of the method for processing a substrate shown in FIG. 4.
FIG. 6 is a diagram illustrating an example of an underlying film UF of the substrate W.
FIG. 7 is a diagram illustrating an example of an underlying film UF of the substrate W.
FIG. 8 is a diagram illustrating an example of a cross-sectional structure of the substrate W after development.
FIG. 9 is a flowchart illustrating a method for processing a substrate according to a second embodiment.
FIG. 10A, FIG. 10B, and FIG. 10C are each a timing chart of an example illustrating a method for processing a substrate according to a third embodiment.
FIG. 11 is a flowchart illustrating a method for processing a substrate according to a fourth embodiment.
FIG. 12A and FIG. 12B are each a diagram illustrating an example of a cross-sectional structure of the substrate W after the processing in the operation ST42.
FIG. 13A is a diagram illustrating an example of a cross-sectional structure of the substrate W after the processing in the operation ST43, and FIG. 13B is a diagram illustrating an example of a cross-sectional structure of the substrate W after the processing in the operation ST45.
FIG. 14A is a schematic cross-sectional view illustrating another configuration example of the heat treatment system, and FIG. 14B is a schematic plan view illustrating another configuration example of the heat treatment system.
FIG. 15 is a schematic diagram illustrating a configuration example of a substrate support.
FIG. 16 is a block diagram for describing a configuration example of a system SS for processing a substrate.
FIG. 17 is a flowchart illustrating a method MT.
FIG. 18A and FIG. 18B are each a diagram showing a result of an experiment.
FIG. 19A to FIG. 19D are each a diagram showing a result of an experiment.
FIG. 20 is a diagram showing a result of an experiment.
FIG. 21 is a diagram showing a result of an experiment.
FIG. 22 is a diagram showing a result of an experiment.
FIG. 23A to FIG. 23C are each a diagram showing a result of an experiment.
FIG. 24A and FIG. 24B are each a diagram showing a result of an experiment.
FIG. 25 is a diagram showing a result of an experiment.
FIG. 26 is a diagram showing a result of an experiment.

### Description of Embodiments

A method for processing a substrate according to one example embodiment of the present disclosure includes (a) providing a substrate having an underlying film and a resist film provided on the underlying film and formed of a metal-containing resist, on a substrate support in a processing chamber, and the metal-containing resist has a first region and a second region. The method for processing a substrate further includes (b) dry-developing the resist film by supplying a processing gas containing a carboxylic acid into the processing chamber, exposing the substrate to the carboxylic acid, and selectively removing the second region with respect to the first region. In the (b), a pressure or a partial pressure of the carboxylic acid is 0.3 Torr (40 Pa) or more and less than 100 Torr (13,332 Pa).

Hereinafter, embodiments of the present disclosure will be described with reference to the drawings. The same or similar elements in the drawings are denoted by the same reference numerals, and the overlapping description will be omitted. Unless otherwise specifically described, the positional relationship such as up, down, left, and right will be described based on the positional relationship shown in the drawings. The dimensional ratios in the drawings do not indicate actual ratios, and the actual ratios are not limited to the shown ratios.

### <Configuration Example of Heat Treatment System>

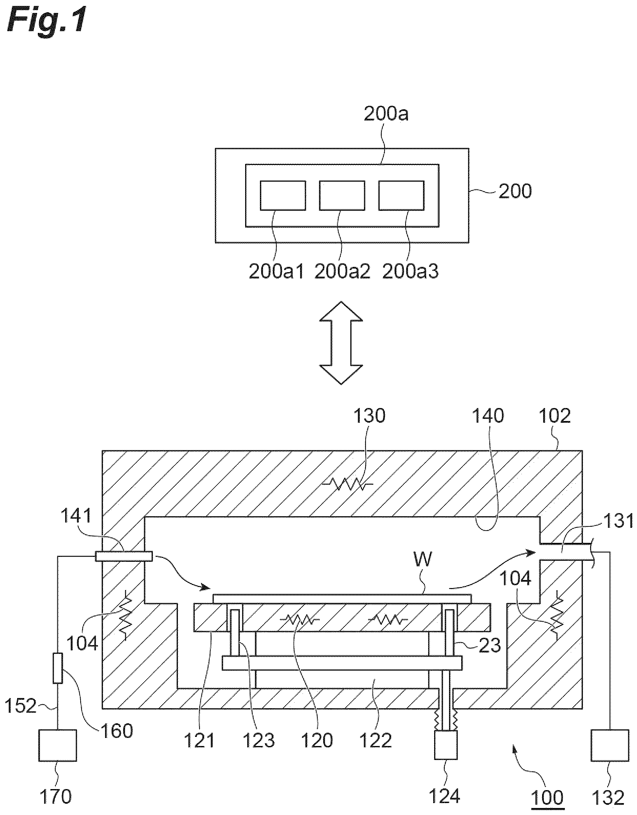

FIG. 1 is a diagram for describing a configuration example of a heat treatment system. In one embodiment, the heat treatment system includes a heat treatment apparatus 100 and a controller 200. The heat treatment system is an example of the system for processing a substrate, and the heat treatment apparatus 100 is an example of an apparatus for processing a substrate.

The heat treatment apparatus 100 has a processing chamber 102 that is configured to be sealable. The processing chamber 102 is, for example, an airtight cylindrical container, and is configured to be able to adjust the atmosphere inside. A side wall heater 104 is disposed in a side wall of the processing chamber 102. A ceiling heater 130 is disposed in a ceiling wall (top plate) of the processing chamber 102. A ceiling surface 140 of the ceiling wall (top plate) of the processing chamber 102 is formed as a horizontal flat surface, and a temperature thereof is adjusted by the ceiling heater 130.

A substrate support 121 is disposed in a lower side in the processing chamber 102. The substrate support 121 configures a placing portion on which the substrate W is placed. The substrate support 121 is formed, for example, in a circular shape in a plan view, and the substrate W is placed on a horizontally formed surface (upper surface) of the substrate support 121. A stage heater 120 is embedded in the substrate support 121. The stage heater 120 is capable of heating the substrate W placed on the substrate support 121. A ring assembly (not shown) may be disposed on the substrate support 121 to surround the substrate W. The ring assembly may include one or a plurality of annular members. By disposing the ring assembly around the substrate W, it is possible to improve the temperature controllability of an outer peripheral region of the substrate W. The ring assembly may be formed of an inorganic material or an organic material depending on the desired heat treatment.

The substrate support 121 is supported in the processing chamber 102 by a columnar support 122 disposed on a bottom surface of the processing chamber 102. A plurality of lift pins 123 that can be vertically moved up and down are disposed on an outer side of the columnar support 122 in a circumferential direction. Each of the plurality of lift pins 123 is inserted into a through-hole provided in the substrate support 121. The plurality of lift pins 123 are arranged at intervals in the circumferential direction. The lifting operation of the plurality of lift pins 123 is caused by a lift mechanism 124. In a case where the lift pin 123 protrudes from the surface of the substrate support 121, the substrate W can be delivered between a transfer mechanism (not shown) and the substrate support 121.

An exhaust port 131 having an opening is provided in a side wall of the processing chamber 102. The exhaust port 131 is connected to an exhaust mechanism 132 via an exhaust pipe. The exhaust mechanism 132 is provided with a vacuum pump, a valve, and the like, and adjusts an exhaust flow rate from the exhaust port 131. The pressure in the processing chamber 102 is adjusted by adjusting the exhaust flow rate and the like by means of the exhaust mechanism 132. A transfer port (not shown) of the substrate W is formed to be freely opened and closed, in the side wall of the processing chamber 102 at a position different from a position at which the exhaust port 131 is opened.

In addition, a gas nozzle 141 is disposed at a position in the side wall of the processing chamber 102, which is different from the positions of the exhaust port 131 and the transfer port of the substrate W. The gas nozzle 141 supplies the processing gas into the processing chamber 102. The gas nozzle 141 is disposed on a side opposite to the exhaust port 131 as viewed from a central portion of the substrate support 121, in the side wall of the processing chamber 102. That is, the gas nozzle 141 is disposed in the side wall of the processing chamber 102 symmetrically with respect to the exhaust port 131 on a vertical imaginary plane passing through the central portion of the substrate support 121.

The gas nozzle 141 is formed in a rod shape that protrudes from the side wall of the processing chamber 102 toward the center side of the processing chamber 102. A distal end portion of the gas nozzle 141 extends, for example, horizontally from the side wall of the processing chamber 102. The processing gas is discharged into the processing chamber 102 from a discharge port that is open at a distal end of the gas nozzle 141, flows in a direction of a one-dot chain line arrow shown in FIG. 1, and is exhausted from the exhaust port 131. The distal end portion of the gas nozzle 141 may have a shape extending obliquely downward toward the substrate W, or may have a shape extending obliquely upward toward the ceiling surface 140 of the processing chamber 102.

The gas nozzle 141 may be disposed, for example, in the ceiling wall of the processing chamber 102. In addition, the exhaust port 131 may be provided in the bottom surface of the processing chamber 102.

The heat treatment apparatus 100 has a gas supply pipe 152 connected to the gas nozzle 141 from the outer side of the processing chamber 102. A pipe heater 160 for heating the gas in the gas supply pipe 152 is disposed around the gas supply pipe 152. The gas supply pipe 152 is connected to a gas supply 170. The gas supply 170 includes at least one gas source and at least one flow rate controller. The gas supply may include a vaporizer for vaporizing a material in a liquid state.

The controller 200 processes computer-executable instructions for causing the heat treatment apparatus 100 to perform various operations described in the present disclosure. The controller 200 may be configured to control each component of the heat treatment apparatus 100 to perform various operations described herein. In one embodiment, a part or all of the controller 200 may be included in the heat treatment apparatus 100. The controller 200 may include a processor 200a1, a storage 200a2, and a communication interface 200a3. The controller 200 is realized by, for example, a computer 200a. The processor 200a1 may be configured to read out a program from the storage 200a2 and execute the read out program to perform various control operations. This program may be stored in the storage 200a2 in advance, or may be acquired via the medium when necessary. The acquired program is stored in the storage 200a2, and is read out from the storage 200a2 and executed by the processor 200a1. The medium may be various storage media readable by the computer 200a, or may be a communication line connected to the communication interface 200a3. The processor 200a1 may be a central processing unit (CPU). The storage 200a2 may include a random access memory (RAM), a read only memory (ROM), a hard disk drive (HDD), a solid state drive (SSD), or combinations thereof. The communication interface 200a3 may be communicated with the heat treatment apparatus 100 via a communication line such as a local area network (LAN).

### <Configuration Example of Plasma Processing System>

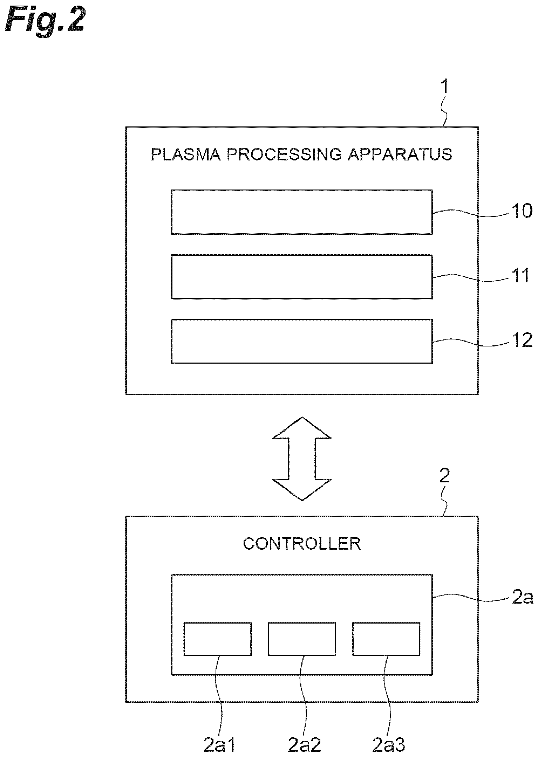

Fig. 2 illustrates a configuration example in case where a plasma processing system is used as a development processing system. In an embodiment, the plasma processing system includes a plasma processing apparatus 1 and a controller 2. The plasma processing system is an example substrate processing system, and the plasma processing apparatus 1 is an example substrate processing apparatus. The plasma processing apparatus 1 includes a plasma processing chamber 10, a substrate support 11, and a plasma generator 12. The plasma processing chamber 10 has a plasma processing space. The plasma processing chamber 10 further has at least one gas inlet for supplying at least one process gas into the plasma processing space and at least one gas outlet for exhausting gases from the plasma processing space. The gas inlet is connected to a gas supply 20 described below and the gas outlet is connected to a gas exhaust system 40 described below. The substrate support 11 is disposed in a plasma processing space and has a substrate supporting surface for supporting a substrate.

The plasma generator 12 is configured to generate a plasma from the at least one process gas supplied into the plasma processing space. The plasma formed in the plasma processing space may be, for example, a capacitively coupled plasma (CCP), an inductively coupled plasma (ICP), an electron-cyclotron-resonance (ECR) plasma, a helicon wave plasma (HWP), or a surface wave plasma (SWP). Various types of plasma generators may also be used, such as an alternating current (AC) plasma generator and a direct current (DC) plasma generator. In an embodiment, AC signal (AC power) used in the AC plasma generator has a frequency in a range of 100 kHz to 10 GHz. Hence, examples of the AC signal include a radio frequency (RF) signal and a microwave signal. In an embodiment, the RF signal has a frequency in a range of 100 kHz to 150 MHz.

The controller 2 processes computer executable instructions causing the plasma processing apparatus 1 to perform various operations described in this disclosure. The controller 2 may be configured to control individual components of the plasma processing apparatus 1 such that these components perform the various operations. In an embodiment, the functions of the controller 2 may be partially or entirely incorporated into the plasma processing apparatus 1. The controller 2 is implemented in, for example, a computer 2a. The controller 2 may include a processor 2a1, a storage 2a2, and a communication interface 2a3. Each component of the controller 2 may be the same as each component of the aforementioned controller 200 (see, Fig. 1).

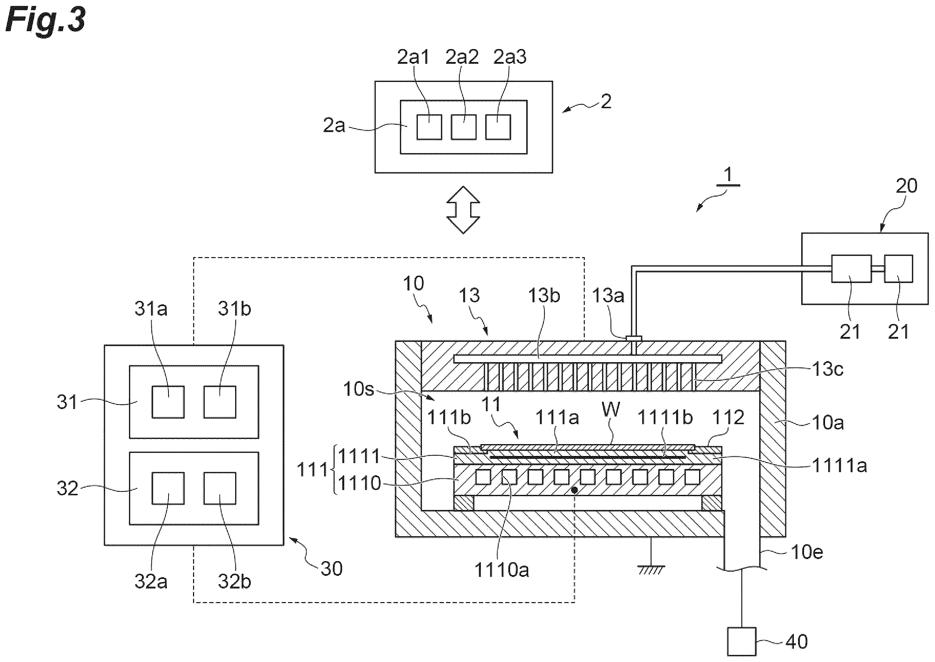

An example configuration of a capacitively coupled plasma processing apparatus, which is an example of the plasma processing apparatus 1, will now be described. Fig. 3 illustrates the example configuration of the capacitively coupled plasma processing apparatus.

The capacitively coupled plasma processing apparatus 1 includes a plasma processing chamber 10, a gas supply 20, an electric power source 30, and a gas exhaust system 40. The plasma processing apparatus 1 further includes a substrate support 11 and a gas introduction unit. The gas introduction unit is configured to introduce at least one process gas into the plasma processing chamber 10. The gas introduction unit includes a showerhead 13. The substrate support 11 is disposed in a plasma processing chamber 10. The showerhead 13 is disposed above the substrate support 11. In an embodiment, the showerhead 13 functions as at least part of the ceiling of the plasma processing chamber 10. The plasma processing chamber 10 has a plasma processing space 10s that is defined by the showerhead 13, the sidewall 10a of the plasma processing chamber 10, and the substrate support 11. The plasma processing chamber 10 is grounded. The showerhead 13 and the substrate support 11 are electrically insulated from the housing of the plasma processing chamber 10.

The substrate support 11 includes a body 111 and a ring assembly 112. The body 111 has a central region 111a for supporting a substrate W and an annular region 111b for supporting the ring assembly 112. An example of the substrate W is a wafer. The annular region 111b of the body 111 surrounds the central region 111a of the body 111 in plan view. The substrate W is disposed on the central region 111a of the body 111, and the ring assembly 112 is disposed on the annular region 111b of the body 111 so as to surround the substrate W on the central region 111a of the body 111. Thus, the central region 111a is also called a substrate supporting surface for supporting the substrate W, while the annular region 111b is also called a ring supporting surface for supporting the ring assembly 112.

In an embodiment, the body 111 includes a base 1110 and an electrostatic chuck 1111. The base 1110 includes a conductive member. The conductive member of the base 1110 can function as a lower electrode. The electrostatic chuck 1111 is disposed on the base 1110. The electrostatic chuck 1111 includes a ceramic member 1111a and an electrostatic electrode 1111b disposed in the ceramic member 1111a. The ceramic member 1111a has the central region 111a. In an embodiment, the ceramic member 1111a also has the annular region 111b. Any other member, such as an annular electrostatic chuck or an annular insulting member, surrounding the electrostatic chuck 1111 may have the annular region 111b. In this case, the ring assembly 112 may be disposed on either the annular electrostatic chuck or the annular insulating member, or both the electrostatic chuck 1111 and the annular insulating member. At least one RF/DC electrode coupled to an RF source 31 and/or a DC source 32 described below may be disposed in the ceramic member 1111a. In this case, the at least one RF/DC electrode functions as the lower electrode. If a bias RF signal and/or DC signal described below are supplied to the at least one RF/DC electrode, the RF/DC electrode is also called a bias electrode. It is noted that the conductive member of the base 1110 and the at least one RF/DC electrode may each function as a plurality of lower electrodes. The electrostatic electrode 1111b may also be function as a lower electrode. The substrate support 11 accordingly includes at least one lower electrode.

The ring assembly 112 includes one or more annular members. In an embodiment, the annular members include one or more edge rings and at least one cover ring. The edge ring is formed of a conductive or insulating material, whereas the cover ring is formed of an insulating material.

The substrate support 11 may also include a temperature adjusting module that is configured to adjust at least one of the electrostatic chuck 1111, the ring assembly 112, and the substrate to a target temperature. The temperature adjusting module may be a heater, a heat transfer medium, a flow passage 1110a, or any combination thereof. A heat transfer fluid, such as brine or gas, flows into the flow passage 1110a. In an embodiment, the flow passage 1110a is formed in the base 1110, one or more heaters are disposed in the ceramic member 1111a of the electrostatic chuck 1111. The substrate support 11 may further include a heat transfer gas supply configured to supply a heat transfer gas to a gap between the rear surface of the substrate W and the central region 111a.

The showerhead 13 is configured to introduce at least one process gas from the gas supply 20 into the plasma processing space 10s. The showerhead 13 has at least one gas inlet 13a, at least one gas diffusing space 13b, and a plurality of gas feeding ports 13c. The process gas supplied to the gas inlet 13a passes through the gas diffusing space 13b and is then introduced into the plasma processing space 10s from the gas feeding ports 13c. The showerhead 13 further includes at least one upper electrode. The gas introduction unit may include one or more side gas injectors provided at one or more openings formed in the sidewall 10a, in addition to the showerhead 13.

The gas supply 20 may include at least one gas source 21 and at least one flow controller 22. In an embodiment, the gas supply 20 is configured to supply at least one process gas from the corresponding gas source 21 through the corresponding flow controller 22 into the showerhead 13. Each flow controller 22 may be, for example, a mass flow controller or a pressure-controlled flow controller. The gas supply 20 may include a flow modulation device that can modulate or pulse the flow of the at least one process gas.

The electric power source 30 include an RF source 31 coupled to the plasma processing chamber 10 through at least one impedance matching circuit. The RF source 31 is configured to supply at least one RF signal (RF power) to at least one lower electrode and/or at least one upper electrode. A plasma is thereby formed from at least one process gas supplied into the plasma processing space 10s. Thus, the RF source 31 can function as at least part of the plasma generator 12. The bias RF signal supplied to the at least one lower electrode causes a bias potential to occur in the substrate W, which potential then attracts ionic components in the plasma to the substrate W.

In an embodiment, the RF source 31 includes a first RF generator 31a and a second RF generator 31b. The first RF generator 31a is coupled to the at least one lower electrode and/or the at least one upper electrode through the at least one impedance matching circuit and is configured to generate a source RF signal (source RF power) for generating a plasma. In an embodiment, the source RF signal has a frequency in a range of 10 MHz to 150 MHz. In an embodiment, the first RF generator 31a may be configured to generate a plurality of source RF signals having different frequencies. The resulting source RF signal(s) is supplied to the at least one lower electrode and/or the at least one upper electrode.

The second RF generator 31b is coupled to the at least one lower electrode through the at least one impedance matching circuit and is configured to generate a bias RF signal (bias RF power). The bias RF signal and the source RF signal may have the same frequency or different frequencies. In an embodiment, the bias RF signal has a frequency which is less than that of the source RF signal. In an embodiment, the bias RF signal has a frequency in a range of 100 kHz to 60 MHz. In an embodiment, the second RF generator 31b may be configured to generate a plurality of bias RF signals having different frequencies. The resulting bias RF signal(s) is supplied to the at least one lower electrode. In various embodiments, at least one of the source RF signal and the bias RF signal may be pulsed.

The electric power source 30 may also include a DC source 32 coupled to the plasma processing chamber 10. The DC source 32 includes a first DC generator 32a and a second DC generator 32b. In an embodiment, the first DC generator 32a is connected to the at least one lower electrode and is configured to generate a first DC signal. The resulting first DC signal is applied to the at least one lower electrode. In an embodiment, the second DC generator 32b is connected to the at least one upper electrode and is configured to generate a second DC signal. The resulting second DC signal is applied to the at least one upper electrode.

In various embodiments, the first and second DC signals may be pulsed. In this case, a sequence of voltage pulses is applied to the at least one lower electrode and/or the at least one upper electrode. The voltage pulses have rectangular, trapezoidal, or triangular waveform, or a combined waveform thereof. In an embodiment, a waveform generator for generating a sequence of voltage pulses from the DC signal is disposed between the first DC generator 32a and the at least one lower electrode. The first DC generator 32a and the waveform generator thereby functions as a voltage pulse generator. In the case that the second DC generator 32b and the waveform generator functions as a voltage pulse generator, the voltage pulse generator is connected to the at least one upper electrode. The voltage pulse may have positive polarity or negative polarity. A sequence of voltage pulses may also include one or more positive voltage pulses and one or more negative voltage pulses in a cycle. The first and second DC generators 32a, 32b may be disposed in addition to the RF source 31, or the first DC generator 32a may be disposed in place of the second RF generator 31b.

The gas exhaust system 40 may be connected to, for example, a gas outlet 10e provided in the bottom wall of the plasma processing chamber 10. The gas exhaust system 40 may include a pressure regulation valve and a vacuum pump. The pressure regulation valve enables the pressure in the plasma processing space 10s to be adjusted. The vacuum pump may be a turbo-molecular pump, a dry pump, or a combination thereof.

### <Method for Processing Substrate>

Hereinafter, various embodiments of the method for processing a substrate in the present disclosure will be described.

### [First Embodiment]

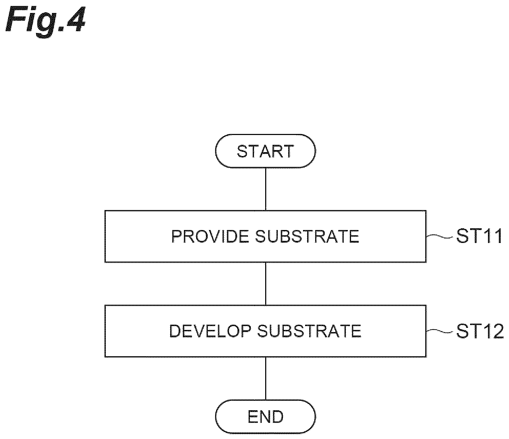

FIG. 4 is a flowchart illustrating a method for processing a substrate (hereinafter, also referred to as a "method MT1") according to the first embodiment. As shown in FIG. 4, the method MT1 includes an operation ST11 of providing a substrate and an operation ST12 of developing the substrate. In one embodiment, the development processing in the operation ST12 is performed by a dry process (hereinafter, also referred to as "dry development") using a processing gas.

The method MT1 may be performed by using any one of the above-described systems for processing a substrate (refer to FIGS. 1 to 3), or may be performed by using two or more of these systems for processing a substrate. For example, the method MT1 may be performed by a heat treatment system (refer to FIG. 1). In the following, the method MT1 will be described by taking a case where the controller 200 controls each component of the heat treatment apparatus 100 to apply the method MT1 to the substrate W, as an example.

### (Operation ST11: Provision of Substrate)

First, in an operation ST11, the substrate W is provided in the processing chamber 102 of the heat treatment apparatus 100. The substrate W is provided on the substrate support 121 via the lift pin 123. After the substrate W is disposed on the substrate support 121, the temperature of the substrate support 121 is adjusted to a set temperature. The temperature of the substrate support 121 may be adjusted by controlling the output of one or more heaters of the side wall heater 104, the stage heater 120, the ceiling heater 130, and the pipe heater 160 (hereinafter, also collectively referred to as "each heater"). In the method MT1, the temperature of the substrate support 121 may be adjusted to the set temperature before the operation ST11. That is, after the temperature of the substrate support 121 is adjusted to the set temperature, the substrate W may be provided on the substrate support 121.

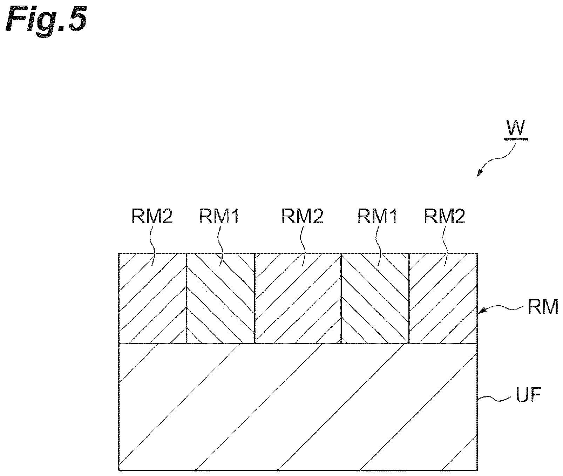

FIG. 5 is a diagram illustrating an example of a cross-sectional structure of a substrate W provided in the operation ST11 of the method for processing a substrate shown in FIG. 4. The substrate W includes an underlying film UF and a resist film RM formed on the underlying film UF. The substrate W may be used for manufacturing a semiconductor device. The semiconductor device includes, for example, a memory device such as a DRAM or a 3D-NAND flash memory, and a logic device.

The resist film RM is a metal-containing resist film that contains a metal. In one example, the metal may include at least one metal selected from the group consisting of Sn, Hf, and Ti. In one example, the resist film RM may contain Sn, and may contain tin oxide (SnO bond) or tin hydroxide (Sn-OH bond). The resist film RM may further contain an organic substance.

As shown in FIG. 5, the resist film RM has an exposed first region RM1 and an unexposed second region RM2. The first region RM1 is a region exposed to EUV light, that is, an EUV exposure region. The second region RM2 is a region that is not exposed to the EUV light, that is, an unexposed region.

The underlying film UF may be an organic film, a dielectric film, a metal film, a semiconductor film, or a laminated film of these, formed on a silicon wafer.

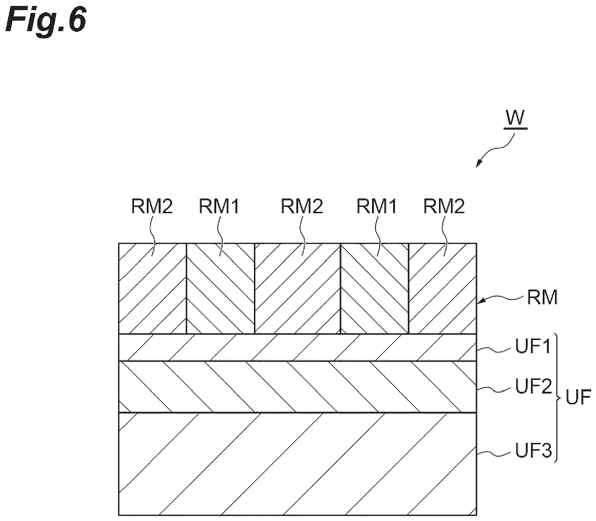

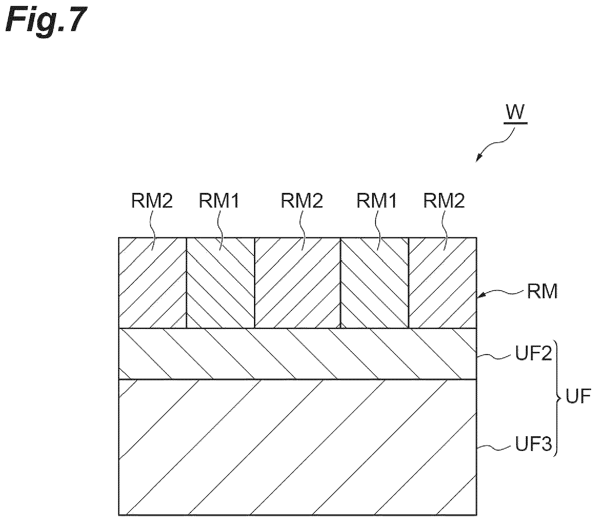

FIGS. 6 and 7 are diagrams illustrating examples of the underlying film UF of the substrate W, respectively. As shown in FIG. 6, the underlying film UF may be provided with a first film UF 1, a second film UF2, and a third film UF3. As shown in FIG. 7, the underlying film UF may be provided with the second film UF2 and the third film UF3.

The first film UF1 is, for example, a spin-on glass (SOG) film, a SiC film, a SiON film, a Si-containing anti-reflective coating (SiARC) film, or an organic film. The second film UF2 is, for example, a spin-on carbon (SOC) film, an amorphous carbon film, or a silicon-containing film. The third film UF3 is, for example, a silicon-containing film. The silicon-containing film is, for example, a silicon oxide film, a silicon nitride film, a silicon oxynitride film, a silicon carbon nitride film, a polycrystalline silicon film, or a carbon-containing silicon film. The third film UF3 may be provided with a plurality of types of laminated silicon-containing films. For example, the third film UF3 may be provided with a silicon oxide film and a silicon nitride film which are alternately laminated. In addition, the third film UF3 may be provided with a silicon oxide film and a polycrystalline silicon film which are alternately laminated. In addition, the third film UF3 may be a laminated film including a silicon nitride film, a silicon oxide film, and a polycrystalline silicon film. In addition, the third film UF3 may be composed of a laminated silicon oxide film and silicon carbon nitride film. In addition, the third film UF3 may be a laminated film including a silicon oxide film, a silicon nitride film, and a silicon carbon nitride film.

In one embodiment, the substrate W is formed as follows. First, a photoresist film containing a metal is formed on an underlying film which has been subjected to an adhesion improving processing or the like. The film formation may be performed by a dry process, a wet process such as a solution coating method, or both the dry process and the wet process. Before forming the photoresist film, surface reforming processing of the underlying film may be performed. The substrate after the formation of the photoresist film is subjected to a heating treatment, that is, a pre bake (post apply bake (PAB)). After the pre bake, the substrate may be subjected to an additional heating treatment. The substrate after the heating treatment is transferred to an exposure device, and the photoresist film is irradiated with EUV light via an exposure mask (reticle). As a result, the substrate W including the underlying film UF and the resist film RM having the exposed first region RM1 and the unexposed second region RM2 is formed. The first region RM1 is a region corresponding to an opening provided in the exposure mask (reticle). The second region RM2 is a region corresponding to a pattern provided on the exposure mask (reticle). The EUV light has, for example, a wavelength in the range of 10 to 20 nm. The EUV light may have a wavelength in the range of 11 to 14 nm, and has a wavelength of 13.5 nm in one example. The substrate W after the exposure is transferred from the exposure device to the heat treatment apparatus under atmosphere control, and is subjected to a heating treatment, that is, a post exposure bake (PEB). After the PEB, the substrate W may be subjected to an additional heating treatment.

### (Operation ST12: Development of Substrate)

Next, in an operation ST12, the second region RM2 of the substrate W is selectively removed by exposing the substrate W to the processing gas, and the resist film RM is developed.

In the operation ST12, the processing gas is supplied into the processing chamber 102 via the gas nozzle 141. In one embodiment, the processing gas includes a carboxylic acid. In one embodiment, the carboxylic acid may be formic acid (HCOOH). In one embodiment, the carboxylic acid may be acetic acid (CH₃COOH). In one embodiment, the carboxylic acid may contain a halogen element, and may contain fluorine and/or chlorine as the halogen element. The carboxylic acid containing fluorine may be, for example, at least one selected from the group consisting of monofluoroacetic acid (CFH₂COOH), difluoroacetic acid (CF₂HCOOH), and trifluoroacetic acid (CF₃COOH), and may be trifluoroacetic acid. The carboxylic acid containing chlorine may be, for example, at least one selected from the group consisting of monochloroacetic acid (CClH₂COOH), dichloroacetic acid (CCl₂HCOOH), and trifluoroacetic acid (CCl₃COOH). The carboxylic acid containing fluorine and chlorine may be, for example, chlorofluoroacetic acid. In one embodiment, the carboxylic acid may be at least one selected from the group consisting of formic acid, acetic acid, and trifluoroacetic acid, may be formic acid and/or trifluoroacetic acid, and may be trifluoroacetic acid.

The processing gas may further contain an inert gas. The inert gas may be a nitrogen gas or a noble gas such as Ar. In addition, the processing gas may further contain an inorganic acid other than the inert gas, or may further contain an organic acid other than the carboxylic acid. In addition, the processing gas may contain an oxidizing gas such as an O₂ gas and/or a CO₂ gas.

In addition, in the operation ST12, the pressure of the processing gas in the processing chamber 102 is adjusted. More specifically, the pressure of the carboxylic acid in the processing gas is adjusted. In a case where the processing gas contains only a carboxylic acid, that is, in a case where the processing gas is a single gas, the pressure of the carboxylic acid in the processing gas is the pressure of the processing gas. In a case where the processing gas is a mixed gas containing the carboxylic acid and a gas other than the carboxylic acid, the pressure of the carboxylic acid in the processing gas is a partial pressure of the carboxylic acid in the processing gas. Hereinafter, the pressure of the processing gas in a case where the processing gas is a single gas and the partial pressure of the carboxylic acid in the processing gas in a case where the processing gas is a mixed gas may be referred to as "pressure of carboxylic acid". The pressure of the carboxylic acid may be adjusted by a flow rate of the carboxylic acid supplied into the processing chamber 102 and/or a flow rate of the carboxylic acid exhausted from the processing chamber 102. In a case where the processing gas is a mixed gas, the pressure of the carboxylic acid can be adjusted by the flow rate of the gas of the carboxylic acid supplied into the processing chamber 102 and the flow rate of the gas other than the carboxylic acid and/or the flow rate of the gas of the carboxylic acid exhausted from the processing chamber 102 and the flow rate of the gas other than the carboxylic acid.

In one embodiment, the partial pressure of the carboxylic acid in the operation ST12 may be 0.3 Torr (40 Pa) or more, 0.5 Torr (66.6 Pa) or more, 1 Torr (133 Pa) or more, 1.5 Torr (200 Pa) or more, 2 Torr (266) or more, or 5 Torr (666 Pa) or more. In addition, the partial pressure of the carboxylic acid may be less than 100 Torr (13,332 Pa), 90 Torr (12,000 Pa) or less, 80 Torr (13,332 Pa) or less, 70 Torr (9,333 Pa) or less, 60 Torr (8,000 Pa) or less, or 10 Torr (1,333 Pa) or less. In one embodiment, the pressure of the carboxylic acid may be 1 Torr or more and less than 100 Torr. In a case where the pressure of the carboxylic acid is 1 Torr or more, a higher development speed may be achieved, and a higher throughput may be achieved. On the other hand, in a case where the pressure of the carboxylic acid is less than 100 Torr, a higher development contrast (selectivity) may be achieved along with a high development speed.

In addition, in the operation ST12, a temperature of the substrate W or the substrate support 121 may be controlled. In one embodiment, the temperature of the substrate support 121 in the operation ST12 may be -20°C or higher, 0°C or higher, 20°C or higher, 90°C or higher, or 120°C or higher. In addition, the temperature of the substrate support 121 in the operation ST12 may be 300°C or lower, 220°C or lower, 210°C or lower, or 200°C or lower. In one embodiment, the temperature of the substrate support 121 is controlled to be -20°C or higher and 220°C or lower. In a case where the temperature of the substrate support 121 is 0°C or higher, a decrease in the development speed may be suppressed. On the other hand, in a case where the temperature of the substrate support 121 is lower than 200°C, a high development contrast (selectivity) may be achieved along with a high development speed. The temperature of the substrate support 121 may be controlled by the power supplied to the stage heater 120. In addition, the temperature of the substrate support 121 may be controlled by power supplied to the side wall heater 104 and/or the ceiling heater 130 together with the stage heater 120 or instead of the stage heater 120. In addition, the temperature of the substrate support 121 may be controlled by using an infrared lamp, a microwave, or the like, together with the power supplied to each of the above-described heaters, or instead of the power supplied to each of the above-described heaters.

In a case where the carboxylic acid in the processing gas is formic acid in the operation ST12, the temperature of the substrate support 121 may be 120°C or higher. In a case where the carboxylic acid in the processing gas is formic acid in the operation ST12, the pressure of the carboxylic acid may be 0.3 Torr or more or 0.5 Torr or more. In a case where the carboxylic acid in the processing gas is trifluoroacetic acid in the operation ST12, the temperature of the substrate support 121 may be 90°C or higher, or may be 120°C or higher. In a case where the carboxylic acid in the processing gas is trifluoroacetic acid in the operation ST12, the pressure of the carboxylic acid may be 0.3 Torr or more or 0.5 Torr or more. In a case where the carboxylic acid in the processing gas is acetic acid in the operation ST12, the temperature of the substrate support 121 may be 120°C or higher, 150°C or higher, or 180°C or higher. In a case where the carboxylic acid in the processing gas is acetic acid in the operation ST12, the pressure of the carboxylic acid may be 0.3 Torr or more or 0.5 Torr or more.

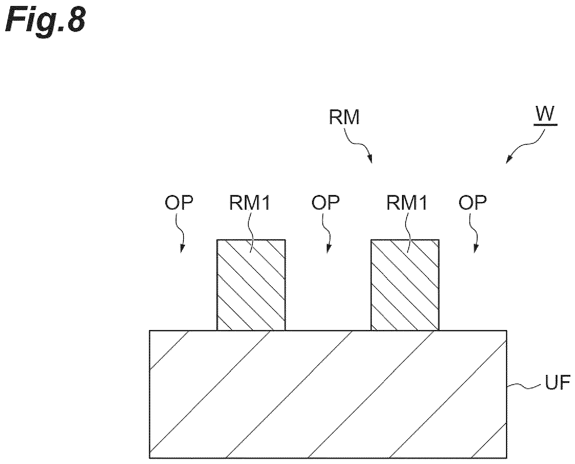

The operation ST12 may be performed until the second region RM2 is removed and the underlying film UF is exposed. FIG. 8 is a diagram illustrating an example of a cross-sectional structure of the substrate W after the development. In the example shown in FIG. 8, the second region RM2 of the resist film RM is removed, and an opening OP is formed. The opening OP is defined by side surfaces of the first region RM1. The opening OP is a space surrounded by the side surfaces on the underlying film UF. The opening OP has a shape corresponding to the second region RM2 (consequently a shape corresponding to the exposure mask pattern used for the EUV exposure) in a plan view of the substrate W. The shape may be, for example, a circle, an ellipse, a rectangle, a line, or a shape obtained by combining one or more of these. A plurality of openings OP may be provided in the resist film RM after the development. The plurality of openings OP may each have a linear shape and may be arranged at regular intervals to form a line and space pattern. In addition, the plurality of openings OP may be arranged in a lattice shape to form a pillar pattern.

According to the first embodiment, the second region RM2 can be removed with a high selectivity (a ratio of the development speed of the second region RM2 to the development speed of the first region RM1, hereinafter, also referred to as a "development contrast") with respect to the first region RM1. In addition, according to the first embodiment, it is possible to suppress the generation of residues due to the development.

Next, a method for processing a substrate according to another embodiment of the present disclosure will be described. In the following, parts overlapping with the first embodiment will be described in a simplified manner or will be omitted.

### [Second Embodiment]

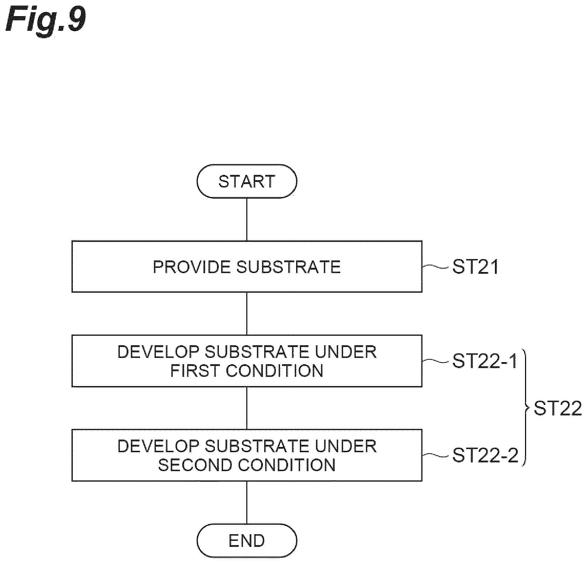

FIG. 9 is a flowchart illustrating a method for processing a substrate (hereinafter, also referred to as a "method MT2") according to a second embodiment. The method MT2 includes an operation ST21 and an operation ST22. In the operation ST21, the substrate W is provided in the same manner as in the operation ST11 of the method MT1. In the subsequent operation ST22, the resist film RM is developed. The operation ST22 includes an operation ST22-1 of developing a part of the resist film under a first condition and an operation ST22-2 of developing the resist film RM under a second condition different from the first condition.

In one embodiment, the combination of the first condition and the second condition may satisfy any one or more of the following conditions (A) to (C), or may satisfy any two or more thereof. In the following description, the pressure of the carboxylic acid is the pressure of the carboxylic acid in a case where the processing gas is a single gas, and is the partial pressure of the carboxylic acid in a case where the processing gas is a mixed gas.
(A) In the operation ST22-1, the resist film RM is developed using a first processing gas, and in the operation ST22-2, the resist film RM is developed using a second processing gas different from the first processing gas.
(B) In the operation ST22-1, the resist film RM is developed by setting the pressure of the carboxylic acid to a first pressure, and in the operation ST22-2, the resist film RM is developed by setting the pressure of the carboxylic acid to a second pressure different from the first pressure.
(C) In the operation ST22-1, the resist film RM is developed by setting the substrate support 121 to a first temperature, and in the operation ST22-2, the resist film RM is developed by setting the substrate support 121 to a second temperature different from the first temperature.

In one example in which the condition (A) is satisfied, a gas containing an inorganic acid may be used as the first processing gas, and a gas containing a carboxylic acid may be used as the second processing gas. The inorganic acid may be a gas having higher acidity than the carboxylic acid. The inorganic acid may be, for example, at least one selected from the group consisting of HBr, BCl₃, HCl, HF, and HI. The carboxylic acid may be any one or more of the above-described carboxylic acids.

In another example in which the condition (A) is satisfied, a gas containing an organic acid other than a carboxylic acid may be used as the first processing gas, and a gas containing the carboxylic acid may be used as the second processing gas. Alternatively, a gas containing a carboxylic acid may be used as the first processing gas, and a gas containing an organic acid other than the carboxylic acid may be used as the second processing gas. Alternatively, a gas containing a carboxylic acid may be used as the first processing gas, and a gas containing a carboxylic acid or an organic acid other than the carboxylic acid having acidity lower than the acidity of the first processing gas may be used as the second processing gas. The organic acid other than the carboxylic acid may be a β-dicarbonyl compound such as acetylacetone (CH₃C(O)CH₂C(O)CH₃), trichloroacetylacetone (CCl₃C(O)CH₂C(O)CH₃), hexachloroacetylacetone (CCl₃C(O)CH₂C(O)CCl₃), trifluoroacetylacetone (CF₃C(O)CH₂C(O)CH₃), hexafluoroacetylacetone (HFAc, CF₃C(O)CH₂C(O)CF₃), or the like, or may be alcohol such as nonafluoro-tert-butyl alcohol ((CF₃)₃C-OH) or the like. The carboxylic acid may be any one or more of the above-described carboxylic acids.

In still another example in which the condition (A) is satisfied, a gas containing a first carboxylic acid may be used as the first processing gas, and a gas containing a second carboxylic acid different from the first carboxylic acid may be used as the second processing gas. The acidity of the second carboxylic acid may be lower than the acidity of the first carboxylic acid. Trifluoroacetic acid may be used as the first carboxylic acid and formic acid or acetic acid may be used as the second carboxylic acid. Alternatively, formic acid may be used as the first carboxylic acid and acetic acid may be used as the second carboxylic acid.

In an example in which the condition (B) is satisfied, a mixed gas containing a carboxylic acid may be used as the processing gas. For example, the processing gas contains a carboxylic acid and an inert gas. In this case, in the operation ST22-1, the partial pressure of the carboxylic acid may be set to the first pressure, and in the operation ST22-2, the partial pressure of the carboxylic acid may be set to the second pressure different from the first pressure. The second pressure may be lower than the first pressure. In one example, the first pressure may be 60 Torr or more and 90 Torr or less, and the second pressure may be 1.5 Torr or more and 20 Torr or less.

In another example in which the condition (B) is satisfied, the processing gas contains a carboxylic acid and an inorganic acid such as HBr. In this case, in the operation ST22-1, the partial pressure of the carboxylic acid may be set to the first pressure, and in the operation ST22-2, the partial pressure of the carboxylic acid may be set to the second pressure different from the first pressure. The second pressure may be higher than the first pressure. In one example, the first pressure may be 30 Torr or more and 50 Torr or less, and the second pressure may be 80 Torr or more and 90 Torr or less.

In an example in which the condition (C) is satisfied, the second temperature may be lower than the first temperature. In one example, the first temperature may be 110°C or higher and 130°C or lower, and the second temperature may be 70°C or higher and 90°C or lower.

According to the method MT2, the development condition is changed depending on the development depth of the resist film RM. Therefore, even in a case where the intensity of the exposure reaction varies in a thickness direction, the second region RM2 can be removed from the first region RM1 with a high selectivity. The change from the first condition to the second condition may be continuous or may be stepwise. In addition, a cycle including the operation ST22-1 and the operation ST22-2 may be repeated a plurality of times.

### [Third Embodiment]

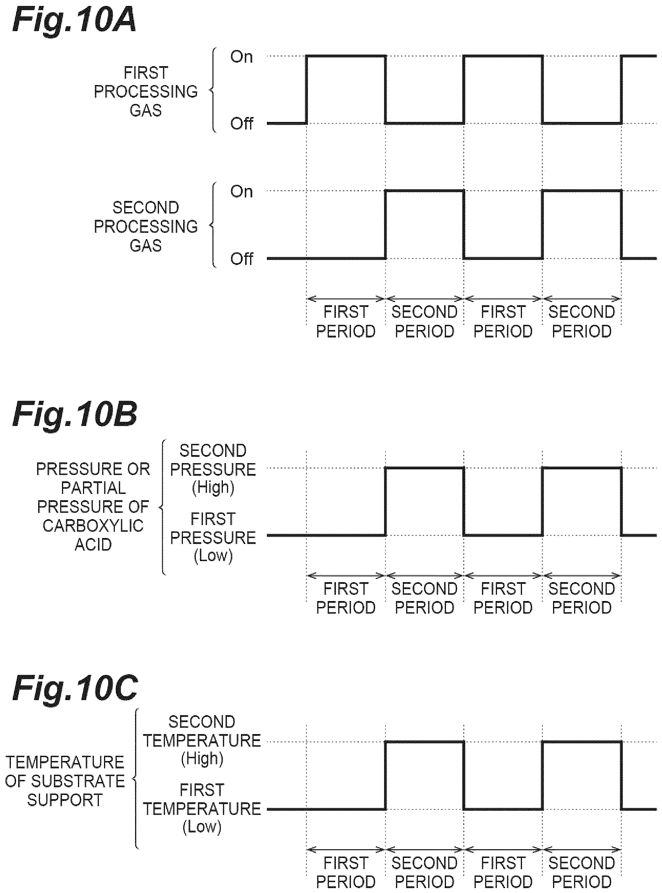

FIG. 10A, FIG. 10B, and FIG. 10C are each a timing chart of an example illustrating a method for processing a substrate according to the third embodiment (hereinafter, also referred to as a "method MT3"). The method MT3 includes an operation ST31 and an operation ST32. In the operation ST31, the substrate W is provided in the same manner as in the operation ST11 of the method MT1. In the subsequent operation ST32, the resist film RM is developed. As shown in FIG. 10A, FIG. 10B, and FIG. 10C, the period during which the operation ST32 is performed includes a first period and a second period alternating with the first period.

In one embodiment, the combination of the processing condition for the first period and the processing condition for the second period may satisfy any one or more of the following conditions (A) to (C), or may satisfy any two or more thereof. In the following description, the pressure of the carboxylic acid is the pressure of the carboxylic acid in a case where the processing gas is a single gas, and is the partial pressure of the carboxylic acid in a case where the processing gas is a mixed gas.
(A) In the first period, the resist film RM is developed using the first processing gas, and in the second period, the resist film RM is developed using the second processing gas different from the first processing gas (refer to FIG. 10A).
(B) In the first period, the resist film RM is developed by setting the pressure of the carboxylic acid to the first pressure, and in the second period, the resist film RM is developed by setting the pressure of the carboxylic acid to the second pressure different from the first pressure (refer to FIG. 10B).
(C) In the first period, the resist film RM is developed by setting the temperature of the substrate support 121 to the first temperature, and in the second period, the resist film RM is developed by setting the temperature of the substrate support 121 to the second temperature different from the first temperature (refer to FIG. 10C).

In one example in which the condition (A) is satisfied, a gas containing an inorganic acid may be used as the first processing gas, and a gas containing a carboxylic acid may be used as the second processing gas. The inorganic acid may be, for example, at least one selected from the group consisting of HBr, BCl3, HCl, and HF. The carboxylic acid may be any one or more of the above-described carboxylic acids.

In another example in which the condition (A) is satisfied, a gas containing an organic acid other than a carboxylic acid may be used as the first processing gas, and a gas containing the carboxylic acid may be used as the second processing gas. Alternatively, a gas containing a carboxylic acid may be used as the first processing gas, and a gas containing an organic acid other than the carboxylic acid may be used as the second processing gas. The gas containing an organic acid other than a carboxylic acid may be, for example, the above-described β-dicarbonyl compound or alcohol. The carboxylic acid may be any one or more of the above-described carboxylic acids.

In still another example in which the condition (A) is satisfied, a gas containing a first carboxylic acid may be used as the first processing gas, and a gas containing a second carboxylic acid different from the first carboxylic acid may be used as the second processing gas. Each of the first carboxylic acid and the second carboxylic acid may be any one or more of the above-described carboxylic acids.

In one example in which the condition (B) is satisfied, the first pressure may be 0 Torr or more and 0.1 Torr or less, and the second pressure may be 1 Torr or more and 10 Torr or less.

In one example in which the condition (C) is satisfied, the first temperature may be 110°C or higher and 130°C or lower, and the second temperature may be 170°C or higher and 190°C or lower.

According to the method MT3, the operation of developing (ST32) includes the first period and the second period alternating with the first period. Therefore, the volatilization of the reaction by-product generated in the operation ST32 is promoted, and the generation of the residue in the operation ST32 may be suppressed. In the timing charts shown in FIG. 10B and FIG. 10C, the pressure of the carboxylic acid and the temperature of the substrate support 121 are both controlled to be "Low" in the first period and "High" in the second period, but may be controlled to be "High" in the first period and "Low" in the second period.

### [Fourth Embodiment]

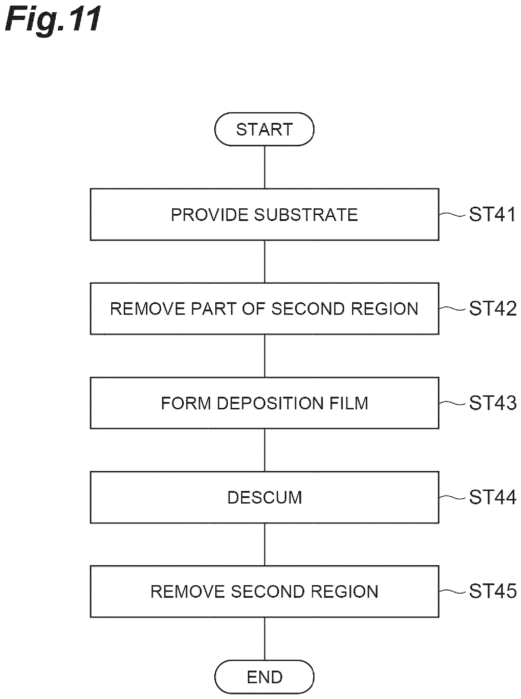

FIG. 11 is a flowchart illustrating a method for processing a substrate (hereinafter, also referred to as a "method MT4") according to the fourth embodiment. The method MT4 includes an operation of providing the substrate W (operation ST41), an operation of removing a part of the second region (operation ST42), an operation of forming a deposition film (operation ST43), a descum operation (operation ST44), and an operation of removing the second region (operation ST45).

In the method MT4, a plasma processing apparatus 1 shown in FIG. 3 may be used as a development processing system. In the method MT4, the heat treatment apparatus 100 as shown in FIG. 1 may also be used, but in this case, the processing chamber 102 may be configured to include a plasma supply unit (not shown) capable of supplying plasma generated outside the processing chamber 102 into the processing chamber 102. In the following, the method MT4 will be described by taking a case where the plasma processing system shown in FIG. 3 is used as the development processing system, as an example.

### (Operations ST41 and ST42)

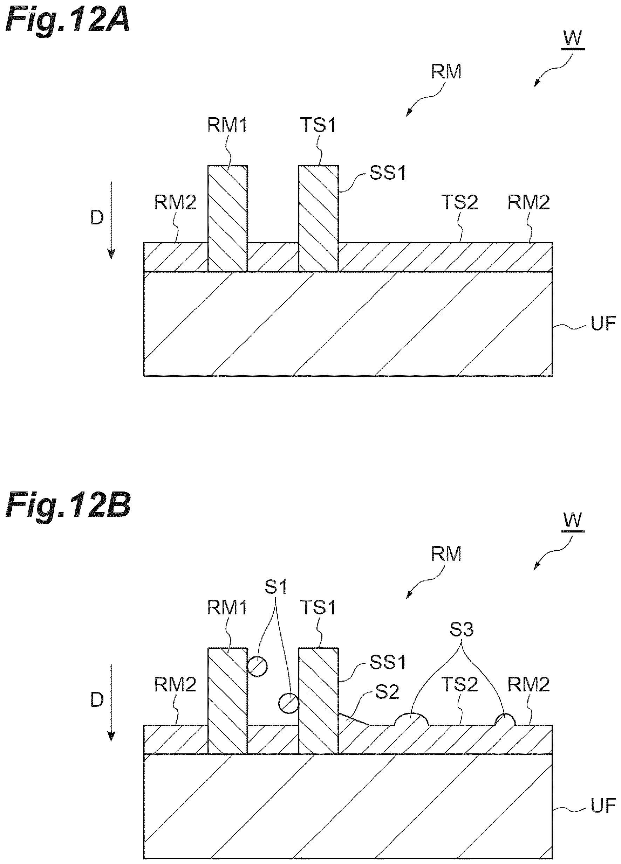

In the operation ST41, the substrate W is provided in the same manner as in the operation ST11. In the subsequent operation ST42, a part of the second region RM2 is removed by the development of the resist film RM. In the operation ST42, the development may be stopped before the underlying film UF is exposed. A part of the second region RM2 may be removed by the same processing as the processing of the operation ST12 described above. The processing gas used in the operation ST42 is the same processing gas as the processing gas used in the operation ST11. Each of FIG. 12A and FIG. 12B is a diagram illustrating an example of a cross-sectional structure of the substrate W after the operation ST42. In the example shown in FIG. 12B, residues (scum) S1 to S3 that cannot be completely removed by the processing in the operation ST42 are generated. The scum S1 to S3 can be removed in the operation ST44 (descum operation) which will be described later.

### (Operation ST43)

In the operation ST43, a deposition film DF is formed. The deposition film DF may be a carbon-containing film or a silicon-containing film. The deposition film DF may be formed by plasma generated from a third processing gas containing a carbon-containing gas or a silicon-containing gas. In one example, first, the third processing gas is supplied into a plasma processing space 10s from the gas supply 20. Next, a source RF signal is supplied to an upper electrode or a lower electrode. Accordingly, a radio frequency electric field is generated in the plasma processing space 10s, and plasma is generated from the third processing gas. Then, a radical containing carbon or silicon included in the plasma may be deposited on at least a part of the resist film RM.

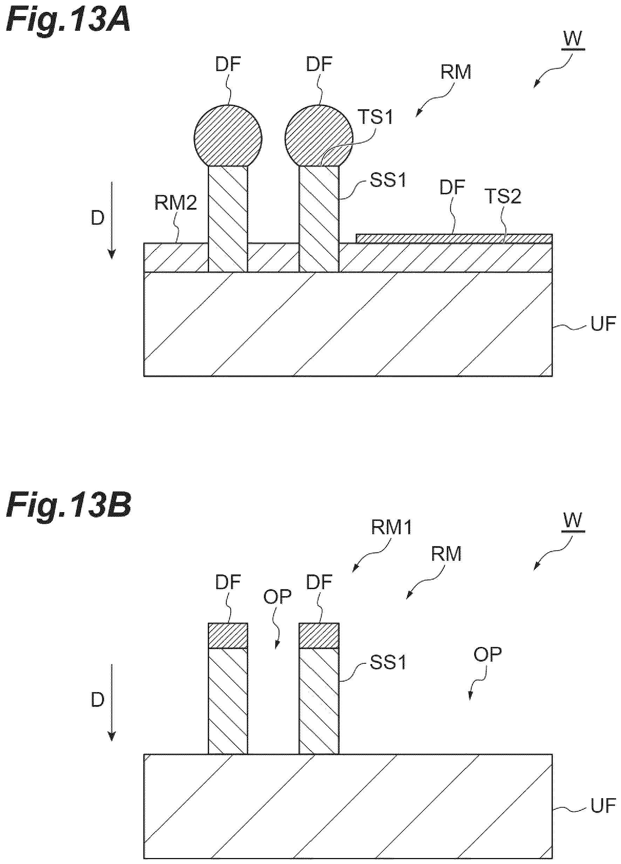

FIG. 13A is a diagram illustrating an example of a cross-sectional structure of the substrate W after the operation ST43. As shown in FIG. 13A, the deposition film DF is formed on an upper surface TS1 of the first region RM1 of the resist film RM (hereinafter, the "first region RM1 of the resist film RM" is also referred to as the "first region RM1"). The deposition film DF may be further formed on at least a part of a side surface SS1 of the first region RM1. In this case, the deposition film DF may be formed thicker on the upper surface TS1 than on the side surface SS1 of the first region RM1. In addition, the deposition film DF may be further deposited on at least a part of an upper surface TS2 of the second region RM2. The deposition film DF may be formed on a part of the upper surface TS2 of the second region RM2, where the space provided by the first region RM1 is wide. In addition, the deposition film DF may be formed thicker on the upper surface TS1 of the first region RM1 than on the upper surface TS2 of the second region RM2.

In a case of forming a carbon-containing film as the deposition film DF, the third processing gas may contain a gas containing carbon and hydrogen. The gas may be, for example, a hydrocarbon (CₓH_{y}: x and y are positive integers, also referred to as a CH-based gas), and in one example, the gas may be a CH₄ gas, a C₂H₂ gas, a C₂H₄ gas, or a C₃H₆ gas. The gas is a fluorocarbon (CxFz: x and z are positive integers, also referred to as a CF-based gas), and in one example, the gas may be C₄F₆ or C₄F₈. In addition, the gas is hydrofluorocarbon (CₓH_{y}F_{z}: x, y, and z are positive integers, also referred to as a CHF-based gas), and in one example, the gas may be a CH₂F₂ gas or a CH₃F gas.

On the other hand, in a case of forming a silicon-containing film as the deposition film DF, the third processing gas may be, for example, a mixed gas of a silicon-containing gas such as SiCl₄ gas or SiF₄ gas, and an oxidizing gas or a hydrogen-containing gas. The oxidizing gas may be, for example, at least one selected from the group consisting of an O₂ gas, a CO gas, and a CO₂ gas. The hydrogen-containing gas may be, for example, H₂ gas. The deposition film DF may be formed by an atomic layer deposition method (hereinafter, also referred to as an "ALD method"). For example, in a case of forming a silicon-containing film as the deposition film DF, the above-described silicon-containing gas may be supplied as a precursor to form a precursor layer on the upper surface TS1 of the first region RM1, and then the oxidizing gas or the hydrogen-containing gas may be supplied to cause the oxidizing gas or the hydrogen-containing gas to react with the precursor layer.

In one embodiment, a silicon-containing film may be formed as the deposition film DF, and then a carbon-containing film may be formed. In this case, the operation ST44 which will be described later may be performed at the same time as the formation of the carbon-containing film. In one embodiment, a carbon-containing film may be formed as the deposition film DF, and then a silicon-containing film may be formed. In this case, the operation ST44 which will be described later may be performed at the same time as the formation of the silicon-containing film. In the operation ST43, a bias signal (bias RF signal or pulsed first DC signal) does not need to be supplied to a lower electrode of the substrate support 11.

### (Operation ST44)

As described above, in a case where scum is generated in the operation ST42, the descum operation (operation ST44) may be performed to remove the scum. As shown in FIG. 12B, the scum may include scum S1 formed on the side wall of the first region RM1, scum S2 extending from the lower portion of the exposed portion of the first region RM1 toward the surface of the second region RM2, and scum S3 formed on the surface of the second region RM2. In the operation ST44, the scum S1 to S3 may be removed by the plasma generated from a fourth processing gas. In one example, first, the fourth processing gas is supplied into the plasma processing space 10s from the gas supply 20. Next, the source RF signal is supplied to the upper electrode or the lower electrode. Accordingly, a radio frequency electric field is generated in the plasma processing space 10s, and plasma is generated from the fourth processing gas. In this case, the bias signal may be supplied to the lower electrode of the substrate support 11. Then, the scum S1 to S3 are removed by the plasma generated from the fourth processing gas.

In the operation ST44, the fourth processing gas may contain at least one selected from the group consisting of a helium-containing gas, a hydrogen-containing gas, a bromine-containing gas, and a chlorine-containing gas. In one example, the fourth processing gas may contain at least one selected from the group consisting of a helium gas, a hydrogen gas, a hydrogen bromide gas, and a boron trichloride gas. The fourth processing gas may further contain a noble gas such as Ar gas or an inert gas such as N₂ gas.

In the operation ST44, a part of the deposition film DF may be removed together with the scum S1 to S3. For example, a part of the deposition film DF formed on the upper surface TS1 of the first region RM1 may also be removed. The deposition film DF can be removed in both the thickness direction and the width direction. In addition, in the operation ST44, some or all of the remainder of the second region RM2 may be removed together with the scum S1 to S3. That is, the operation ST44 and the operation ST45, which will be described later, may be performed at the same time.

### (Operation ST45)

Next, in operation ST45, the second region RM2 is further removed. In the operation ST45, the second region RM2 may be removed by the plasma generated from a fifth processing gas. In one example, first, the fifth processing gas is supplied into the plasma processing space 10s from the gas supply 20. Next, the source RF signal is supplied to the upper electrode or the lower electrode. Accordingly, a radio frequency electric field is generated in the plasma processing space 10s, and plasma is generated from the fifth processing gas. In this case, the bias signal may be supplied to the lower electrode of the substrate support 11. Then, the second region RM2 is removed by means of the radicals included in the plasma generated from the fifth processing gas.

An operation of heating the substrate W may be performed after the operation ST42 and before the operation ST45. In this case, the operation ST43 and the operation ST44 may be omitted. The temperature of the substrate W in the operation of heating the substrate W may be 180°C or higher or 190°C or higher. The temperature of the substrate W in the operation of heating the substrate W may be 240°C or lower or 220°C or lower. In addition, the operation of heating the substrate W and the operation ST45 may be performed by using a single chamber or may be performed by using two or more different chambers. That is, the chamber used for performing the operation of heating the substrate W and the chamber used in the operation ST45 may be the same chamber, that is, a single chamber, or may be different chambers.

FIG. 13B is a diagram illustrating an example of a cross-sectional structure of the substrate W after the processing in the operation ST45. As shown in FIG. 13B, in the operation ST45, the second region RM2 is removed. In the operation ST45, the entire deposition film DF formed on the second region RM2 may be removed. Then, the opening OP defined by the side surface SS1 of the first region RM1 is formed on the underlying film UF. The upper surface of the underlying film UF is exposed at the opening OP.

In the operation ST45, the parameters of the plasma processing for removing the second region RM2 may be appropriately set according to the dimension (critical dimension (CD)) of the first region RM1. The dimension may be a target dimension after the operation ST14 is performed.

In the operation ST45, the fifth processing gas may be at least one selected from the gases listed as the above-described first processing gas, and may be the same gas as the first processing gas. The fifth processing gas may be at least one selected from the gases listed as the above-described fourth processing gas, and may be the same gas as the fourth processing gas. The operation ST45 can also be performed by the heat treatment apparatus 100 without generating plasma. In this case, the fifth processing gas may be supplied into the processing chamber 102, the pressure in the processing chamber may be controlled to a predetermined pressure, and the temperature of the substrate W or the substrate support 121 may be adjusted to a predetermined temperature.

In the method MT4, after a part of the second region RM2 is removed in the operation ST42, the operation ST43, the operation ST44, and the operation ST45 may be performed at the same time. That is, after the operation ST42 is performed, the third processing gas, the fourth processing gas, and the fifth processing gas are supplied into the plasma processing space 10s from the gas supply 20. Next, the source RF signal is supplied to the upper electrode or the lower electrode. Accordingly, a radio frequency electric field is generated in the plasma processing space 10s, and plasma is generated from the third processing gas, the fourth processing gas, and the fifth processing gas. In this case, the bias signal may be supplied to the lower electrode of the substrate support 11. Then, the deposition film DF is formed on the first region RM1 from the radicals generated from the third processing gas. On the other hand, the scum S1 to S3 and the second region RM2 are removed by the radicals generated from the fourth processing gas and the fifth processing gas. That is, the second region RM2 can be removed while the first region RM1 is protected by the deposition film DF. Accordingly, the second region RM2 can be removed while appropriately controlling the dimension of the first region RM1.

In addition, in the method MT4, in the operation ST42, after the second region RM2 is removed and at least a part of the underlying film UF is exposed, the operation ST43, the operation ST44, and the operation ST45 may be performed in this order, or the operation ST43, the operation ST44, and the operation ST45 may be performed at the same time.

According to the method MT4, in a case where the remainder of the second region RM2 or the residue of the second region is removed after removing at least a part of the second region RM2, the first region can be appropriately protected by the deposition film DF. In addition, in the method MT4, since the deposition film DF is formed on the first region RM1 and then the remainder of the second region RM2 or the residue of the second region is removed, the surface roughness due to the unevenness or the like on the side surface SS1 of the first region RM1 and the side surface of the deposition film DF can be reduced.

### [Fifth Embodiment]

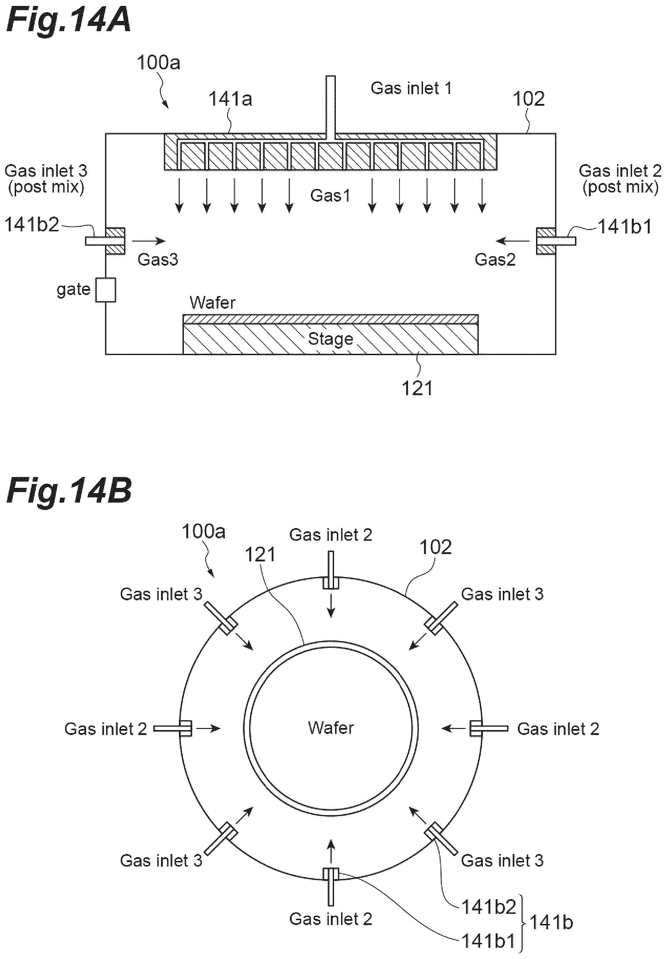

The heat treatment system may include a heat treatment apparatus 100a shown in FIG. 14A and FIG. 14B instead of the heat treatment apparatus 100 shown in FIG. 1. FIG. 14A is a schematic cross-sectional view illustrating a configuration example of the heat treatment apparatus 100a, and FIG. 14B is a schematic plan view illustrating a configuration example of the heat treatment apparatus 100a. The heat treatment apparatus 100a includes a shower head 141a and a plurality of gas nozzles 141b on a side wall. The shower head 141a is disposed in a ceiling of the processing chamber 102. The shower head 141a may be disposed to face the substrate support 121. The plurality of gas nozzles 141b are provided in the side wall of the processing chamber 102. The plurality of gas nozzles 141b may be disposed, for example, at equal intervals along a circumferential direction in the side wall of the processing chamber 102. The plurality of gas nozzles 141b may include a first gas nozzle 141b1 and a second gas nozzle 141b2. The first gas nozzle 141b1 and the second gas nozzle 141b2 may be alternately disposed along the circumferential direction. The types of gases supplied into the processing chamber 102 from the shower head 141a, the first gas nozzle 141b1, and the second gas nozzle 141b2 may be the same as or different from each other. In addition, the flow rates of the gases supplied into the processing chamber 102 from the shower head 141a, the first gas nozzle 141b1, and the second gas nozzle 141b2 may be the same as or different from each other. A heater (not shown) may be disposed in each of the substrate support 121 and the side wall of the processing chamber 102 in the same manner as the heat treatment apparatus 100. In addition, a gas exhaust port (not shown) may be disposed in a bottom surface side of the processing chamber 102.

According to the heat treatment apparatus 100a, the gas density in the processing chamber 102 can be easily controlled, and the in-plane uniformity in the development of the resist film RM can be improved.

### [Sixth Embodiment]

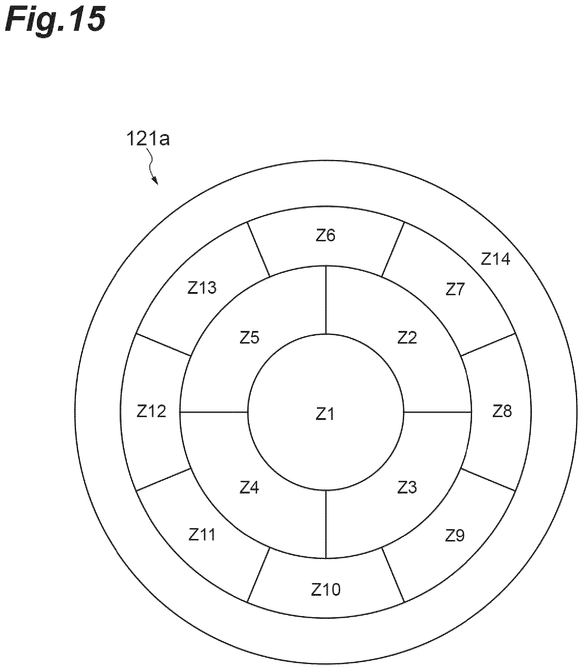

As the substrate support, a substrate support 121a shown in FIG. 15 may be used instead of the substrate support 121 shown in FIG. 1. The substrate support 121a shown in FIG. 15 has a plurality of zones, and each zone is provided with a heater electrode. The plurality of zones are arranged along a surface orthogonal to a central axis of the substrate support 121a or a surface parallel to the substrate W. In the example shown in FIG. 15, the substrate support 121a has zones Z1 to Z14, and each zone is provided with a heater electrode. The heater electrodes in each zone are configured such that power can be supplied independently to each heater electrode. That is, the substrate support 121a is configured to be able to independently control the temperature for each zone. According to the substrate support 121a, the in-plane uniformity in the development of the resist film RM can be improved.

### [Seventh Embodiment]

In a method for processing a substrate according to the present disclosure, a precoat may be performed on the side wall of the processing chamber 102 and/or the parts (hereinafter, also referred to as "in-chamber parts") in the processing chamber 102, such as the substrate support 121, before the start of the substrate processing (development). The precoat may be performed by an atomic layer deposition method (hereinafter, also referred to as an "ALD method"), a chemical vapor deposition method (hereinafter, also referred to as a "CVD method"), or the like. As the gas for forming the precoat, a gas capable of forming a film having resistance to the processing gas containing a carboxylic acid may be selected. In one example, a silicon-containing gas such as aminosilane or SiCl₄ can be used. In this case, a silicon oxide film can be formed as a precoat on the side wall of the processing chamber 102 and/or the in-chamber parts. Accordingly, it is possible to suppress the corrosion of the side wall of the processing chamber 102 and/or the substrate support 121 or the like due to the processing gas.

Instead of the precoat or together with the precoat, the side wall of the processing chamber 102 and/or the in-chamber parts may be made of a material having resistance to the processing gas containing a carboxylic acid or the like.

In addition, in the method for processing a substrate according to the present disclosure, the inside of the processing chamber 102 may be cleaned after the substrate processing (development). In this case, a cleaning gas is supplied into the processing chamber 102 after heating the processing chamber 102 and the in-chamber parts. As the cleaning gas, for example, a gas containing a hydrogen halide such as HBr or HF can be used. The cleaning may be performed by a thermal atomic layer etching method (hereinafter, also referred to as a "thermal ALE method"). Accordingly, it is possible to remove the metal oxide attached to the side wall of the processing chamber 102 and/or the in-chamber parts during development.

### [Eighth Embodiment]

In a method for processing a substrate according to the eighth embodiment, the underlying film UF is etched using the resist film RM developed by any of the methods MT1 to MT4 as a mask. The etching conditions for the underlying film UF may be selected based on the film type of the underlying film UF or the like. In one embodiment, the etching of the underlying film UF is performed by the plasma processing apparatus 1 shown in FIG. 3.

### <Configuration Example of System for Processing Substrate>

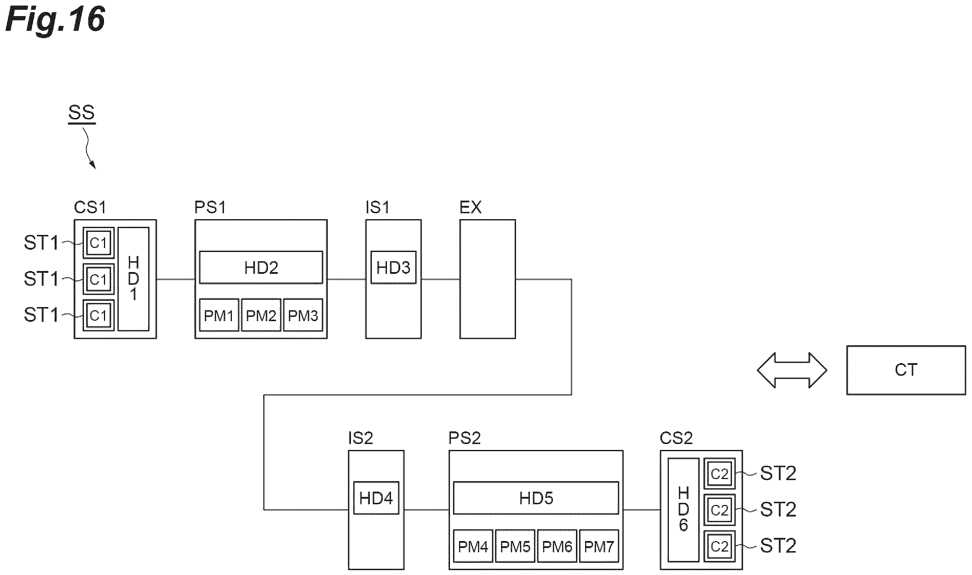

FIG. 16 is a block diagram for describing a configuration example of a system SS for processing a substrate according to an example embodiment. The system SS for processing a substrate includes a first carrier station CS1, a first processing station PS1, a first interface station IS1, an exposure device EX, a second interface station IS2, a second processing station PS2, a second carrier station CS2, and a controller CT.

The first carrier station CS1 performs the transferring-in and transferring-out of a first carrier C1 between the first carrier station CS1 and a system external to the system SS for processing a substrate. The first carrier station CS1 has a placing stand having a plurality of first placing plates ST1. The first carrier C1 in a state where a plurality of substrates W are accommodated or in a state where the first carrier C1 is empty is placed on each first placing plate ST1. The first carrier C1 has a housing capable of accommodating the plurality of substrates W inside. In one example, the first carrier C1 is a front opening unified pod (FOUP).

In addition, the first carrier station CS1 transfers the substrate W between the first carrier C1 and the first processing station PS1. The first carrier station CS1 further includes a first transfer device HD1. The first transfer device HD1 is disposed in the first carrier station CS1 to be positioned between the placing stand and the first processing station PS1. The first transfer device HD1 transfers and delivers the substrate W between the first carrier C1 on each first placing plate ST1 and a second transfer device HD2 of the first processing station PS1. The system SS for processing a substrate may further include a load lock module. The load lock module may be disposed between the first carrier station CS1 and the first processing station PS1. The load lock module can switch the pressure inside the load lock module to atmospheric pressure or vacuum. The "atmospheric pressure" may be a pressure inside the first transfer device HD1. The "vacuum" may be a pressure lower than atmospheric pressure, for example, a medium vacuum of 0.1 Pa to 100 Pa. The inside of the second transfer device HD2 may be atmospheric pressure or vacuum. For example, the load lock module may transfer the substrate W from the first transfer device HD1, which is atmospheric pressure, to the second transfer device HD2, which is vacuum, and may transfer the substrate W from the second transfer device HD2, which is vacuum, to the first transfer device HD1, which is atmospheric pressure.

The first processing station PS1 performs various types of processing on the substrate W. In one embodiment, the first processing station PS1 includes a pre-processing module PM1, a resist film forming module PM2, and a first heat treatment module PM3 (hereinafter, also collectively referred to as a "first substrate processing module PMa"). In addition, the first processing station PS1 has a second transfer device HD2 for transferring the substrate W. The second transfer device HD2 transfers and delivers the substrate W between the two designated first substrate processing modules PMa and between the first processing station PS1 and the first carrier station CS1 or the first interface station IS1.

In the pre-processing module PM1, the substrate W is subjected to the preprocessing. In one embodiment, the pre-processing module PM1 includes a temperature adjustment unit that adjusts the temperature of the substrate W, a high-precision temperature adjustment unit that adjusts the temperature of the substrate W with high precision, and the like. In one embodiment, the pre-processing module PM1 includes a surface reforming processing unit that performs surface reforming processing on the substrate W. Each processing unit of the pre-processing module PM1 may be configured to include a heat treatment apparatus 100 (refer to FIG. 1), a plasma processing apparatus 1 (refer to FIGS. 2 and 3), and/or a liquid processing apparatus.

In the resist film forming module PM2, a resist film is formed on the substrate W. In one embodiment, the resist film forming module PM2 includes a dry coating unit. The dry coating unit forms a resist film on the substrate W by using a dry process such as a vapor deposition method. In one example, the dry coating unit includes a CVD device or ALD device that performs chemical vapor deposition of a resist film on the substrate W disposed in the chamber, or a PVD device that performs physical vapor deposition of a resist film on the substrate W disposed in the chamber. The dry coating unit may be the heat treatment apparatus 100 (refer to FIG. 1) or the plasma processing apparatus 1 (refer to FIGS. 2 and 3).

In one embodiment, the resist film forming module PM2 includes a wet coating unit. The wet coating unit forms a resist film on the substrate W by using a wet process such as a solution coating method. In one example, the wet coating unit may be a liquid processing apparatus.

In one embodiment, an example of the resist film forming module PM2 includes both the wet coating unit and the dry coating unit.

In the first heat treatment module PM3, the substrate W is subjected to the heat treatment. In one embodiment, the first heat treatment module PM3 includes any one or more of a pre bake (PAB) unit that performs a heating treatment on the substrate W on which the resist film is formed, a temperature adjustment unit that adjusts the temperature of the substrate W, and a high-precision temperature adjustment unit that adjusts the temperature of the substrate W with high precision. Each of these units may have one or a plurality of heat treatment apparatuses. In one example, the plurality of heat treatment apparatuses may be stacked. For example, the heat treatment apparatus may be the heat treatment apparatus 100 (refer to FIG. 1). Each heat treatment may be performed at a predetermined temperature by using a predetermined gas.

The first interface station IS1 has a third transfer device HD3. The third transfer device HD3 transfers and delivers the substrate W between the first processing station PS1 and the exposure device EX. The third transfer device HD3 may be configured to have a housing that accommodates the substrate W, and may be configured such that the temperature, humidity, pressure, and the like in the housing are controllable.

In the exposure device EX, the resist film on the substrate W is exposed by using an exposure mask (reticle). The exposure device EX may be, for example, an EUV exposure device having a light source generating EUV light.

The second interface station IS2 has a fourth transfer device HD4. The fourth transfer device HD4 transfers and delivers the substrate W between the exposure device EX and the second processing station PS2. The fourth transfer device HD4 may be configured to have a housing that accommodates the substrate W, and may be configured such that the temperature, humidity, pressure, and the like in the housing are controllable.

The second processing station PS2 performs various types of processing on the substrate W. In one embodiment, the second processing station PS2 includes a second heat treatment module PM4, a measurement module PM5, a development module PM6, and a third heat treatment module PM7 (hereinafter, also collectively referred to as a "second substrate processing module PMb"). In addition, the second processing station PS2 has a fifth transfer device HD5 for transferring the substrate W. The fifth transfer device HD5 transfers and delivers the substrate W between the two designated second substrate processing modules PMb and between the second processing station PS2 and the second carrier station CS2 or the second interface station IS2.

In the second heat treatment module PM4, the substrate W is subjected to the heat treatment. In one embodiment, the second heat treatment module PM4 includes any one or more of a post exposure bake (PEB) unit that performs a heating treatment on the substrate W after exposure, a temperature adjustment unit that adjusts the temperature of the substrate W, and a high-precision temperature adjustment unit that adjusts the temperature of the substrate W with high precision. Each of these units may have one or a plurality of heat treatment apparatuses. In one example, the plurality of heat treatment apparatuses may be stacked. For example, the heat treatment apparatus may be the heat treatment apparatus 100 (refer to FIG. 1). Each heat treatment may be performed at a predetermined temperature by using a predetermined gas.

In the measurement module PM5, various measurements are performed on the substrate W. In one embodiment, the measurement module PM5 includes an imaging unit including a placing stand on which the substrate W is placed, an imaging device, an illumination device, and various sensors (a temperature sensor, a reflectivity measuring sensor, and the like). For example, the imaging device may be a CCD camera that images the appearance of the substrate W. Alternatively, the imaging device may be a hyperspectral camera that takes an image by spectrally separating light for each wavelength. The hyperspectral camera can measure any one or more of a pattern shape, a dimension, a film thickness, a composition, and a film density of a resist film.

In the development module PM6, the substrate W is subjected to the development processing. In one embodiment, the development module PM6 includes a dry development unit that performs dry development on the substrate W. The dry development unit may be, for example, the heat treatment apparatus 100 (refer to FIG. 1) or the plasma processing apparatus 1 (refer to FIGS. 2 and 3). In one embodiment, the development module PM6 includes a wet development unit that performs wet development on the substrate W. The wet development unit may be, for example, a liquid processing apparatus. In one embodiment, the development module PM6 includes both the dry development unit and the wet development unit.

In the third heat treatment module PM7, the substrate W is subjected to the heat treatment. In one embodiment, the third heat treatment module PM7 includes any one or more of a post bake (PB) unit that performs a heating treatment on the substrate W after development, a temperature adjustment unit that adjusts the temperature of the substrate W, and a high-precision temperature adjustment unit that adjusts the temperature of the substrate W with high precision. Each of these units may have one or a plurality of heat treatment apparatuses. In one example, the plurality of heat treatment apparatuses may be stacked. For example, the heat treatment apparatus may be the heat treatment apparatus 100 (refer to FIG. 1). Each heat treatment may be performed at a predetermined temperature by using a predetermined gas.

The second carrier station CS2 performs the transferring-in and transferring-out of a second carrier C2 between the second carrier station CS2 and a system external to the system SS for processing a substrate. The configuration and the function of the second carrier station CS2 may be the same as those of the above-described first carrier station CS1.

The controller CT controls each component of the system SS for processing a substrate to perform given processing on the substrate W. The controller CT stores a recipe in which a procedure of the process, a condition of the process, a transfer condition, and the like are set, and controls each component of the system SS for processing a substrate such that the given processing is performed on the substrate W according to the recipe. The controller CT may have some or all of the functions of each controller (the controller 200 and the controller 2 shown in FIGS. 1 to 3, and the controller of the liquid processing apparatus).

### <Example of Method for Processing Substrate>

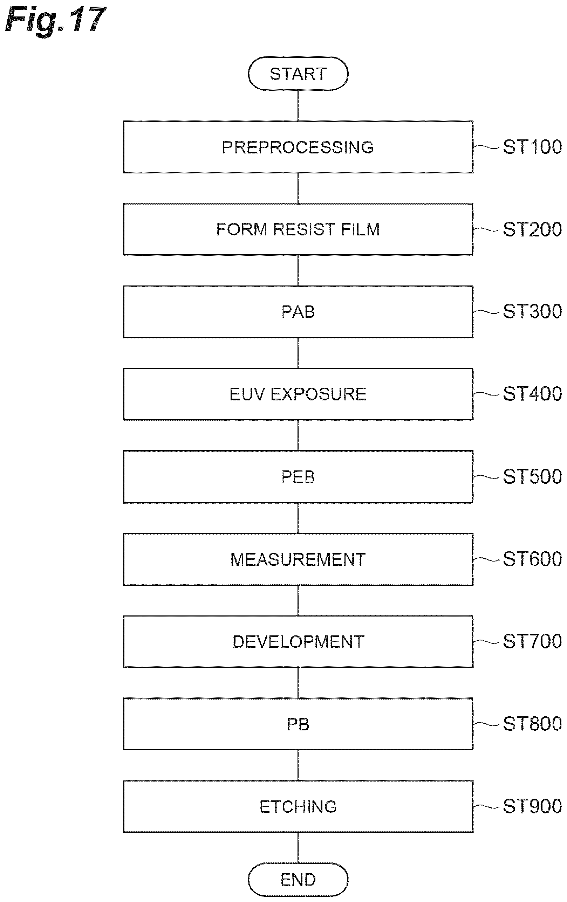

FIG. 17 is a flowchart showing a method for processing a substrate (hereinafter, also referred to as a "method MT") according to an example embodiment. As shown in FIG. 17, the method MT includes an operation ST100 of subjecting a substrate to preprocessing, an operation ST200 of forming a resist film on the substrate, an operation ST300 of subjecting the substrate on which the resist film is formed to a heating treatment (pre bake: PAB), an operation ST400 of subjecting the substrate to EUV exposure, an operation ST500 of subjecting the substrate after the exposure to a heating treatment (post exposure bake: PEB), an operation ST600 of measuring the substrate, an operation ST700 of developing the resist film on the substrate, an operation ST800 of subjecting the substrate after the development to a heating treatment (post bake: PB), and an operation ST900 of etching the substrate. The method MT may not include one or more of the above-described operations. For example, the method MT may not include the operation ST600, and the operation ST700 may be performed after the operation ST500.

The method MT may be executed by using the system SS for processing a substrate shown in FIG. 16. In the following, a case where the controller CT of the system SS for processing a substrate controls each component of the system SS for processing a substrate to perform the method MT on the substrate W will be described as an example.

### (Operation ST100: Preprocessing)

First, the first carrier C1 accommodating the plurality of substrates W is transferred into the first carrier station CS1 of the system SS for processing a substrate. The first carrier C1 is placed on the first placing plate ST1. Next, each substrate W in the first carrier C1 is sequentially taken out by the first transfer device HD1, and delivered to the second transfer device HD2 of the first processing station PS1. The substrate W is transferred to the pre-processing module PM1 by the second transfer device HD2. The pre-processing module PM1 performs the preprocessing on the substrate W. The preprocessing may include, for example, one or more of temperature adjustment of the substrate W, formation of some or all of an underlying film of the substrate W, a heating treatment of the substrate W, and high-precision temperature adjustment of the substrate W. The preprocessing may include the surface reforming processing of the substrate W.

### (Operation ST200: Resist Film Formation)

Next, the substrate W is transferred to the resist film forming module PM2 by the second transfer device HD2. The resist film is formed on the substrate W by the resist film forming module PM2. In one embodiment, the formation of the resist film is performed by a wet process such as a liquid phase deposition method. For example, the resist film is formed by spin-coating the resist film on the substrate W using the wet coating unit of the resist film forming module PM2. In one embodiment, the formation of the resist film on the substrate W is performed by a dry process such as a vapor deposition method. For example, the resist film is formed by vapor-depositing the resist film on the substrate W using the dry coating unit of the resist film forming module PM2.

The formation of the resist film on the substrate W may be performed by using both the dry process and the wet process. For example, the second resist film may be formed on the first resist film by the wet process after the first resist film is formed on the substrate W by the dry process. In this case, the film thicknesses, materials, and/or compositions of the first resist film and the second resist film may be the same as or different from each other.

### (Operation ST300: PAB)

Next, the substrate W is transferred to the first heat treatment module PM3 by the second transfer device HD2. The substrate W is subjected to a heating treatment (pre bake: PAB) by the first heat treatment module PM3. The pre bake may be performed in an air atmosphere or an inert atmosphere. In addition, the pre bake may be performed by heating the substrate W to 50°C or higher and 250°C or lower, 50°C or higher and 200°C or lower, or 80°C or higher and 150°C or lower. In the operation ST200, in a case where the resist film is formed by the dry process, in one embodiment, the pre bake may be continuously performed by the dry coating unit that has performed the operation ST200. In one embodiment, after the pre bake, processing of removing the resist film at the edge of the substrate W (edge bead removal: EBR) may be performed.

### (Operation ST400: EUV Exposure)

Next, the substrate W is delivered to the third transfer device HD3 of the first interface station IS1 by the second transfer device HD2. Then, the substrate W is transferred to the exposure device EX by the third transfer device HD3. The substrate W is subjected to EUV exposure via the exposure mask (reticle) in the exposure device EX. As a result, on the substrate W, a first region where EUV exposure is performed and a second region where EUV exposure is not performed are formed corresponding to a pattern of the exposure mask (reticle).

### (Operation ST500: PEB)

Next, the substrate W is delivered from the fourth transfer device HD4 of the second interface station IS2 to the fifth transfer device HD5 of the second processing station PS2. The substrate W is then transferred to the second heat treatment module PM4 by the fifth transfer device HD5. The substrate W is then subjected to a heating treatment (post exposure bake: PEB) in the second heat treatment module PM4. The post exposure bake may be performed in an air atmosphere. In addition, the post exposure bake may be performed by heating the substrate W to 180°C or higher and 250°C or lower.

### (Operation ST600: Measurement)

Next, the substrate W is transferred to the measurement module PM5 by the fifth transfer device HD5. The measurement module PM5 measures the substrate W. The measurement may be an optical measurement or another measurement. In one embodiment, the measurement by the measurement module PM5 includes measuring the appearance and/or the dimensions of the substrate W using a CCD camera. In one embodiment, the measurement by the measurement module PM5 includes measuring any one or more of a pattern shape, a dimension, a film thickness, a composition, or a film density of the resist film using the hyperspectral camera (hereinafter, also referred to as "pattern shape or the like").

In one embodiment, the controller CT determines the presence or absence of the exposure abnormality of the substrate W based on the measured appearance, dimension, and/or pattern shape of the substrate W. In one embodiment, in a case where the controller CT determines that an exposure abnormality is present, the substrate W may be reworked or discarded without performing the development in operation ST700. The rework of the substrate W may be performed by removing the resist on the substrate W and returning to the operation ST200 to form a resist film again. Rework after development may cause damage to the substrate W, but damage to the substrate W can be avoided or suppressed by performing rework before the development.

### (Operation ST700: Development)

Next, the substrate W is transferred to the development module PM6 by the fifth transfer device HD5. In the development module PM6, the resist film of the substrate W is developed. The development processing may be performed by dry development or by wet development. The development processing may be performed by combining the dry development and the wet development. The development processing in the operation ST700 may be performed by the first method (refer to FIGS. 5 and 11) or the second method (refer to FIG. 12A and FIG. 12B). Desorption processing may be performed once or more after the development processing or during the development processing. The desorption processing includes removing (descumming) a scum from the surface of the resist film or smoothing the surface with an inert gas such as helium or a plasma of the inert gas. In addition, in the development module PM6, after the development processing, a part of the underlying film may be etched using the developed resist film as a mask.

### (Operation ST800: PB)

Next, the substrate W is transferred to the third heat treatment module PM7 by the fifth transfer device HD5 and is subjected to the heating treatment (post bake). The post bake may be performed in an air atmosphere or a reduced pressure atmosphere containing N₂ or O₂. In addition, the post bake may be performed by heating the substrate W to 150°C or higher and 250°C or lower. The post bake may be performed by the second heat treatment module PM4 instead of the third heat treatment module PM7. In one embodiment, the optical measurement of the substrate W may be performed by the measurement module PM5 after the post bake. Such measurement may be performed in addition to the measurement in the operation ST600 or instead of the measurement in the operation ST600. In one embodiment, the controller CT determines the presence or absence of an abnormality such as a defect, a scratch, or an adhesion of a foreign matter in the developed pattern of the substrate W based on the measured appearance, dimensions, and/or pattern shape of the substrate W. In one embodiment, in a case where the controller CT determines that an abnormality is present, the substrate W may be reworked or discarded without performing the etching in operation ST900. In one embodiment, in a case where the controller CT determines that an abnormality is present, an opening dimension of the resist film of the substrate W may be adjusted by using the dry coating unit (CVD device, ALD device, or the like).

### (Operation ST900: Etching)

After the operation ST800 is performed, the substrate W is delivered to a sixth transfer device HD6 of the second carrier station CS2 by the fifth transfer device HD5, and is transferred to the second carrier C2 of the second placing plate ST2 by the sixth transfer device HD6. Thereafter, the second carrier C2 is transferred to the plasma processing system (not shown). In the plasma processing system, the underlying film UF of the substrate W is etched using the resist film after development as a mask. With this, the method MT ends. In the operation ST700, in a case where the resist film is developed using the plasma processing apparatus, the etching may be continuously performed in the plasma processing chamber of the plasma processing apparatus. In addition, in a case where the second processing station PS2 includes a plasma processing module in addition to the development module PM6, the etching may be performed in the plasma processing module. The above-described desorption processing may be performed once or more before the etching or during the etching.

While various exemplary embodiments have been described above, various additions, omissions, substitutions and changes may be made without being limited to the exemplary embodiments described above. Elements of the different embodiments may be combined to form another embodiment.

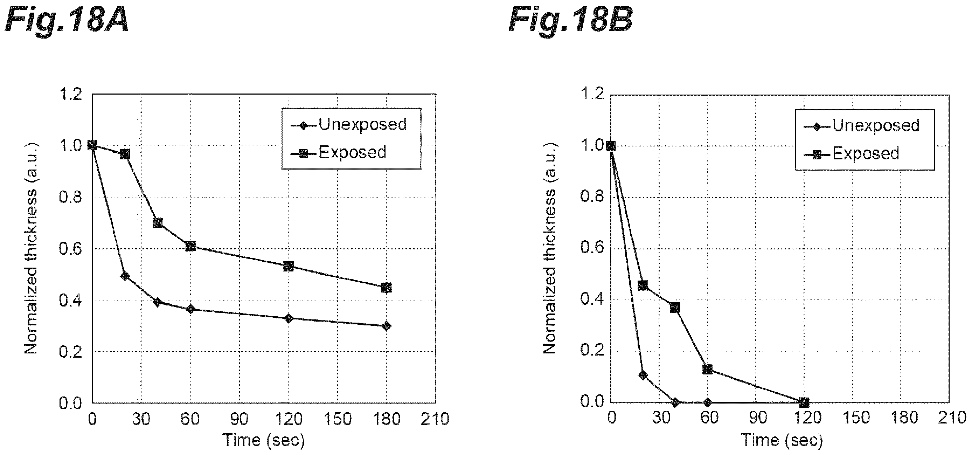

In the following, various experiments will be described together with the results thereof. In the following description, FIG. 18A and FIG. 18B, FIG. 19A to FIG. 19D, FIG. 20 to FIG. 22, FIG. 23A to FIG. 23C, FIG. 24A and FIG. 24A, FIG. 25, and FIG. 26 will be referred to. These drawings show the results of various experiments. In these drawings, "Unexposed" indicates the results of an experiment in which an unexposed resist film is developed, and "Exposed" indicates the results of an experiment in which a resist film exposed to EUV light is developed. In addition, in these drawings, "Thickness" indicates a thickness of the resist film, and "Normalized Thickness" indicates a thickness of the resist film normalized by the thickness of the resist film in a state before development. The resist film was a resist film containing tin oxide. In addition, in the experiments in which the results are shown in these drawings, the heat treatment system shown in FIG. 1 was used. In addition, in the experiments in which the results are shown in these drawings, the relationship between the time (Time) of development and the thickness of the resist film was obtained.

### (Experiment 1)

In Experiment 1, an unexposed resist film and an exposed resist film were developed using a processing gas which is a mixed gas of HBr gas and Ar gas, respectively. In Experiment 1, a partial pressure of the HBr gas was set to 0.2 Torr (26.6 Pa). In Experiment 1, a temperature of the substrate support during development is set to 10°C or 20°C.

FIG. 18A shows the results of the experiment in a case where the temperature of the substrate support during development was 10°C, and FIG. 18B shows the results of the experiment in a case where the temperature of the substrate support during development was 60°C. In the development, in a case where the temperature of the substrate support was 10°C and the HBr gas was used, it was confirmed that the residue of the unexposed resist film tends to be easily generated as shown in FIG. 18A. In addition, in the development, in a case where the temperature of the substrate support was 60°C and the HBr gas was used, it was confirmed that the unexposed resist film can be removed as shown in FIG. 18B, but a difference between a speed of thickness decrease of the unexposed resist film and a speed of thickness decrease of the exposed resist film can be reduced. That is, in a case where the HBr gas was used, it was confirmed that the unexposed region of the resist film can be removed by setting the temperature of the substrate support during development to a high temperature, but the selectivity in the development can be lowered.

### (Experiment 2)

In Experiment 2, the unexposed resist film and the exposed resist film were each developed using a processing gas containing only a carboxylic acid. In Experiment 2, the pressure of the carboxylic acid, that is, the pressure of the processing gas was set to 5 Torr (666 Pa). In Experiment 2, the temperature of the substrate support during the development was set to 120°C. In addition, in Experiment 2, formic acid (H-COOH), trifluoroacetic acid (CF₃-COOH), or acetic acid (CH₃-COOH) was used as the carboxylic acid.

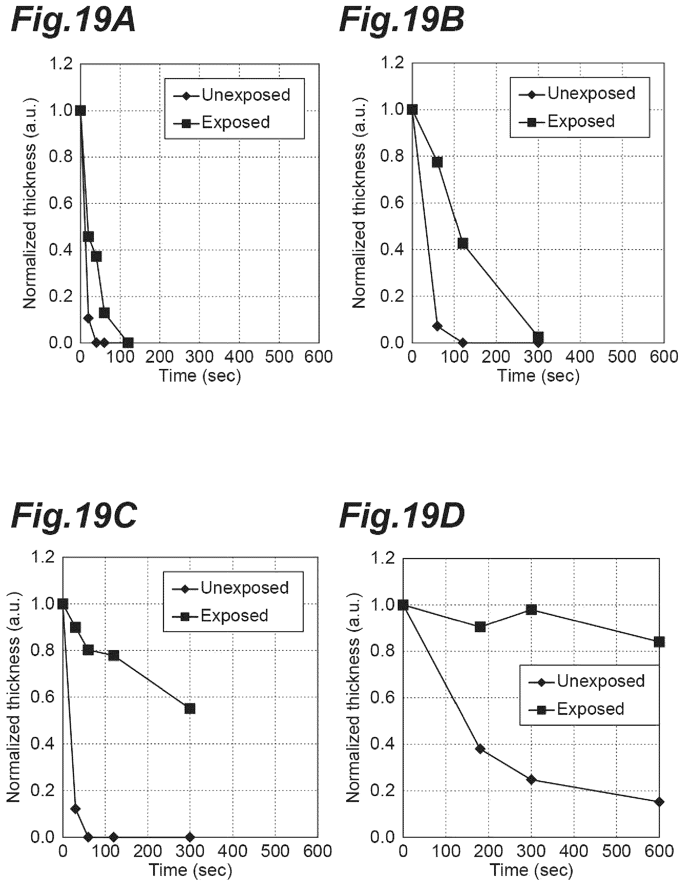

FIG. 19B, FIG. 19C, and FIG. 19D show the results in a case where formic acid, trifluoroacetic acid, and acetic acid were used as the carboxylic acid, respectively. FIG. 19A shows the same results as FIG. 18B. As shown in these drawings, in a case where the carboxylic acid was used in the development, it was confirmed that it is possible to obtain a high selectivity by suppressing a decrease in the thickness of the exposed resist film even in a case where the temperature of the substrate support is high. In addition, it was confirmed that a particularly high development speed is obtained in a case where formic acid or trifluoroacetic acid is used.

### (Experiment 3)

In Experiment 3, the unexposed resist film and the exposed resist film were each developed using a processing gas containing only formic acid (H-COOH). In Experiment 3, the pressure of the formic acid, that is, the pressure of the processing gas was set to 0.5 Torr (66.6 Pa) or 5 Torr (666 Pa). In addition, in Experiment 3, the temperature of the substrate support during development was set to 60°C, 120°C, or 180°C.

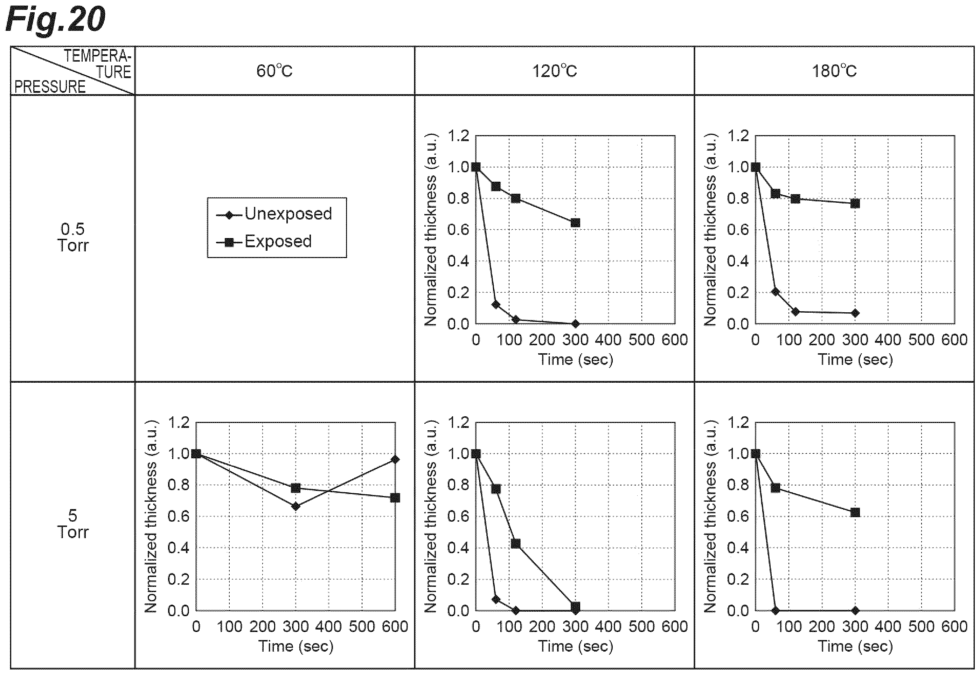

FIG. 20 shows the results of Experiment 3. In a case where the formic acid was used, it was confirmed that development with a high selectivity can be performed at a temperature of 120°C or higher, as shown in FIG. 20. In addition, it was confirmed that a decrease in the thickness of the exposed resist film in a case where the formic acid is used in a state where the temperature of the substrate support is 180°C is further suppressed as compared with a case where the formic acid is used in a state where the temperature of the substrate support is 120°C.

### (Experiment 4)

In Experiment 4, the unexposed resist film and the exposed resist film were each developed using a processing gas containing only trifluoroacetic acid (CF₃-COOH). In Experiment 4, the pressure of the trifluoroacetic acid, that is, the pressure of the processing gas was set to 0.5 Torr (66.6 Pa) or 5 Torr (666 Pa). In addition, in Experiment 4, the temperature of the substrate support during development was set to 60°C, 120°C, or 180°C.

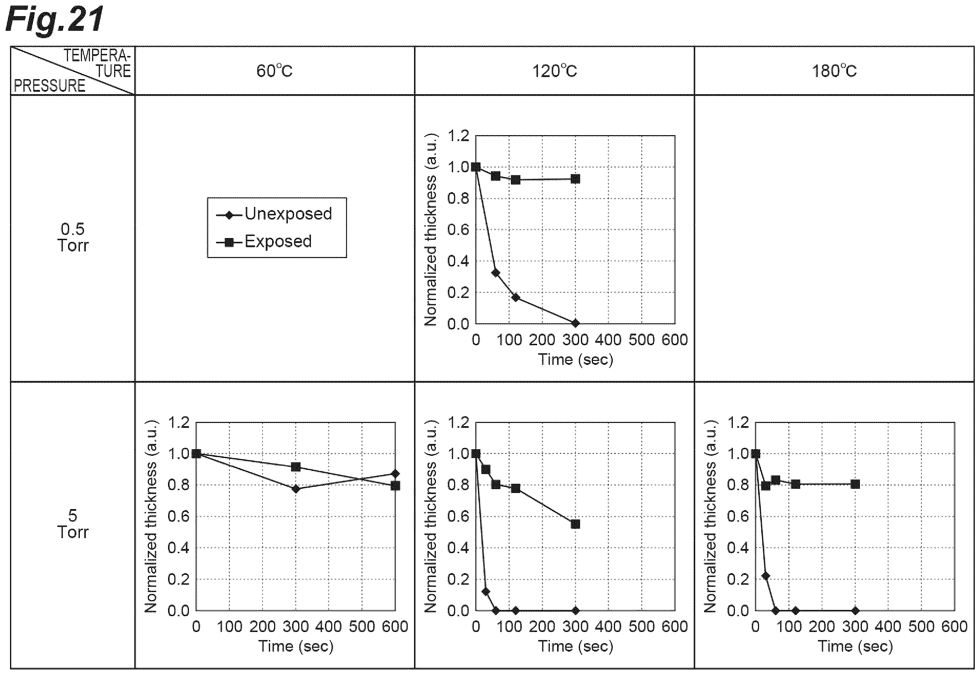

FIG. 21 shows the results of Experiment 4. It was confirmed that in a case where the trifluoroacetic acid is used, development with a high selectivity is possible at a temperature of 120°C or higher, as shown in FIG. 21. In addition, it was confirmed that in a case where the trifluoroacetic acid is used in a state where the temperature of the substrate support is 180°C, the decrease in the thickness of the exposed resist film is further suppressed as compared with a case where the trifluoroacetic acid is used in a state where the temperature of the substrate support was 120°C. In addition, it was confirmed that in a case where the trifluoroacetic acid is used, the decrease in the thickness of the exposed resist film is further suppressed as compared with a case where the formic acid is used.

### (Experiment 5)

In Experiment 5, the unexposed resist film and the exposed resist film were each developed using a processing gas containing only acetic acid (CH₃-COOH). In Experiment 5, the pressure of the acetic acid, that is, the pressure of the processing gas was set to 0.5 Torr (66.6 Pa) or 5 Torr (666 Pa). In addition, in Experiment 5, the temperature of the substrate support during development was set to 120°C or 180°C.

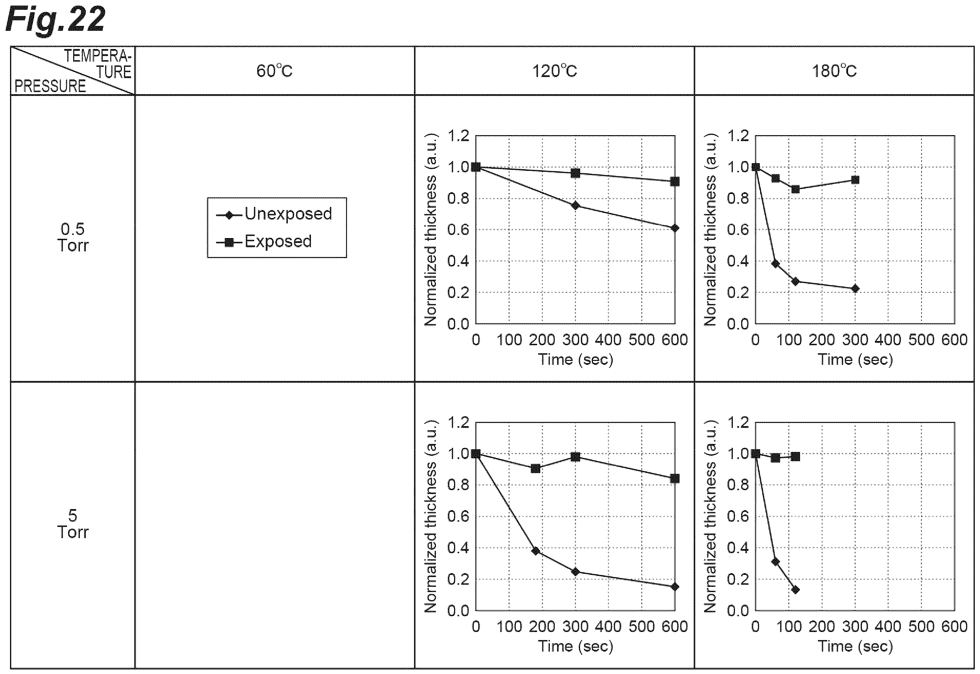

FIG. 22 shows the results of Experiment 5. It was confirmed that in a case where the acetic acid is used, development with a high selectivity can be performed at a temperature of 120°C or higher, as shown in FIG. 22. In addition, it was confirmed that in a case where the acetic acid is used, the decrease in the thickness of the exposed resist film was further suppressed as compared with a case where the formic acid or the trifluoroacetic acid is used, but the speed of the thickness decrease of the unexposed resist film is relatively low.

### (Experiment 6)

In Experiment 6, the unexposed resist film and the exposed resist film were each developed using a processing gas which was a mixed gas of trifluoroacetic acid (CF₃-COOH) and Ar gas as the processing gas. In Experiment 6, the partial pressure of the trifluoroacetic acid was set to 3 Torr (400 Pa). In addition, in Experiment 6, the temperature of the substrate support during development was set to 90°C, 120°C, or 180°C.

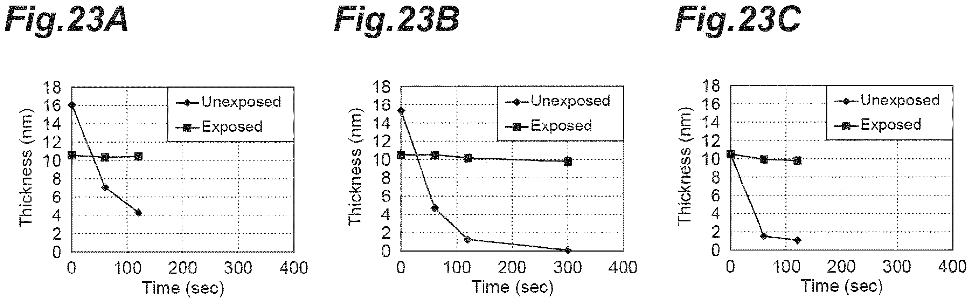

FIG. 23A, FIG. 23B, and FIG. 23C show the results in a case where the temperature of the substrate support during development was 90°C, 120°C, and 180°C, respectively. As shown in these drawings, it was confirmed that in a case where the trifluoroacetic acid is used, development for selectively removing an unexposed region is possible in a case where the substrate support during development is 90°C or higher.

### (Experiment 7)

In Experiment 7, the unexposed resist film and the exposed resist film were each developed using a processing gas which was a mixed gas of trifluoroacetic acid (CF₃-COOH) and Ar gas as the processing gas. In Experiment 7, the temperature of the substrate support during development was set to 120°C. In addition, in Experiment 7, the partial pressure of trifluoroacetic acid was set to 0.36, (48 Pa), 0.6 Torr (80 Pa), 3 Torr (400 Pa), or 6 Torr (798 Pa).

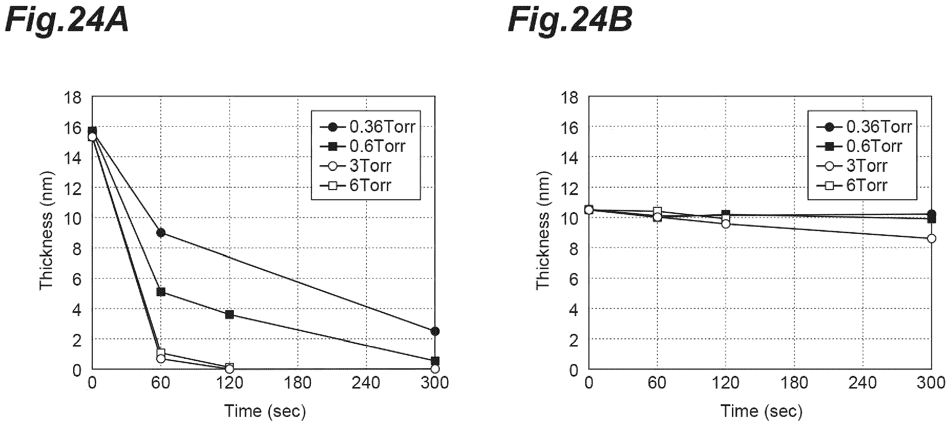

FIG. 24A shows the results of the development of the unexposed resist film, and FIG. 24B shows the results of the development of the exposed resist film. As shown in these drawings, it was confirmed that in a case where the trifluoroacetic acid is used, development for selectively removing the unexposed region is possible by setting the partial pressure of the trifluoroacetic acid to 0.36 Torr or more. In addition, it was confirmed that in a case where the trifluoroacetic acid is used, development with a high selectivity is possible by setting the partial pressure of the trifluoroacetic acid to 0.6 Torr or more.

### (Experiment 8)

In Experiment 8, the unexposed resist film and the exposed resist film were each developed using a processing gas which is a mixed gas of acetic acid (CH₃-COOH) and Ar gas as the processing gas. In Experiment 8, the temperature of the substrate support during development was set to 120°C, 150°C, 180°C, or 210°C. In addition, in Experiment 8, the partial pressure of the acetic acid was set to 0.6 Torr (80 Pa), 3 Torr (400 Pa), or 6 Torr (800 Pa).

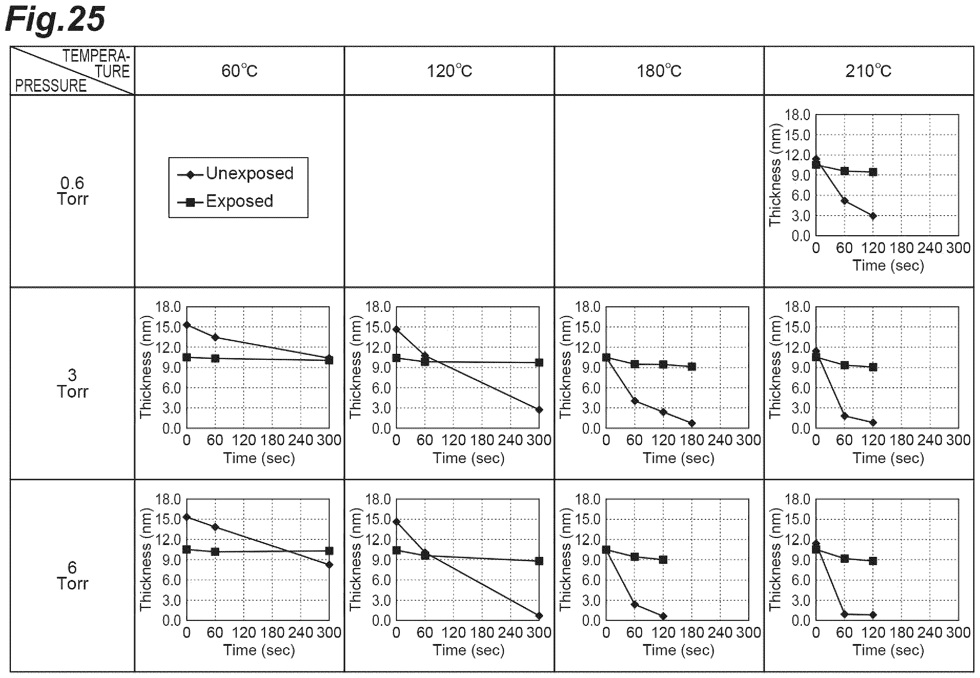

FIG. 25 shows the results of Experiment 8. As shown in FIG. 25, it was confirmed that in a case where the acetic acid is used, development for selectively removing the unexposed region is possible by setting the partial pressure of the acetic acid to 0.6 Torr or more. In addition, it was confirmed that in a case where the acetic acid is used, development for selectively removing the unexposed region is possible by setting the temperature of the substrate support to a temperature of 120°C or higher. In addition, it was confirmed that in a case where the acetic acid is used, the unexposed region is removed at a high speed, that is, a high development speed is obtained by setting the temperature of the substrate support to a temperature of 180°C or higher.

### (Experiment 9)

In Experiment 9, the unexposed resist film and the exposed resist film were each developed using a processing gas which was a mixed gas of acetic acid (CH₃-COOH) and Ar gas as the processing gas. In Experiment 9, the temperature of the substrate support during development was set to 120°C or 150°C. In addition, in Experiment 9, the partial pressure of the acetic acid was set to 6 Torr (800 Pa), 12 Torr (1,600 Pa), 21 Torr (2,800 Pa), 30 Torr (4,000 Pa), or 60 Torr (8,000 Pa).

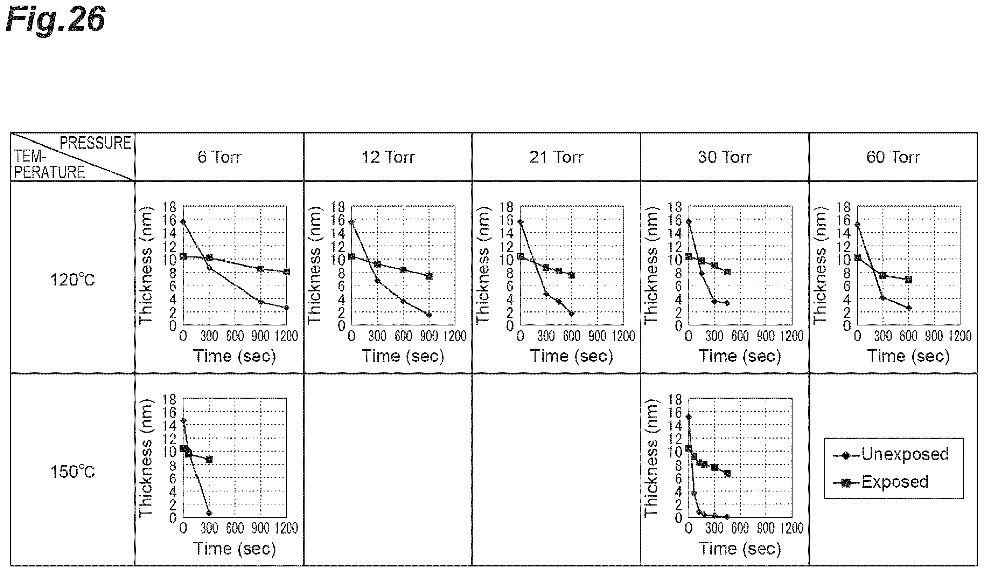

FIG. 26 shows the results of Experiment 9. As shown in FIG. 26, it was confirmed that in a case where the acetic acid is used, development for selectively removing the unexposed region is possible by setting the partial pressure of the acetic acid in a range of 6 Torr to 60 Torr. In addition, it was confirmed that in a case where the acetic acid is used, development for selectively removing the unexposed region is possible by setting the temperature of the substrate support to a temperature of 120°C or higher. In addition, it was confirmed that in a case where the acetic acid is used, the higher the temperature of the substrate support, the faster the unexposed region can be removed, that is, a high development speed can be obtained, as long as the partial pressure of the acetic acid is the same.

Here, various examples in the disclosure are described in the following [E1] to [E19].
[E1] A method for processing a substrate including:
   (a) providing a substrate on a substrate support in a processing chamber, the substrate having an underlying film and a resist film disposed on the underlying film and formed of a metal-containing resist, and the resist film having a first region and a second region; and
   (b) dry-developing the resist film by supplying a processing gas containing a carboxylic acid into the processing chamber, exposing the substrate to the carboxylic acid, and selectively removing the second region with respect to the first region,
   wherein in the (b), a pressure or a partial pressure of the carboxylic acid is 40 Pa or more and less than 13,332 Pa.
[E2] The method for processing a substrate according to E1,
   wherein in the (b), the pressure or the partial pressure of the carboxylic acid is 133 Pa or more.
[E3] The method for processing a substrate according to E1,
   wherein in the (b), the pressure or the partial pressure of the carboxylic acid is 666 Pa or more.
[E4] The method for processing a substrate according to E1,
   wherein in the (b), the pressure or the partial pressure of the carboxylic acid is 1,333 Pa or less.
[E5] The method for processing a substrate according to E1,
   wherein the processing gas contains an inert gas, and in the (b), the partial pressure of the carboxylic acid is 40 Pa or more.
[E6] The method for processing a substrate according to E5,
   wherein the partial pressure of the carboxylic acid is 8,000 Pa or less.
[E7] The method for processing a substrate according to any one of E1 to E6,
   wherein in the (b), a temperature of the substrate support is 90°C or higher.
[E8] The method for processing a substrate according to any one of E1 to E6,
   wherein in the (b), a temperature of the substrate support is 120°C or higher.
[E9] The method for processing a substrate according to any one of E1 to E6,
   wherein in the (b), a temperature of the substrate support is 300°C or lower.
[E10] The method for processing a substrate according to E1,
   wherein the carboxylic acid is at least one selected from the group consisting of formic acid, trifluoroacetic acid, and acetic acid.
[E11] The method for processing a substrate according to E8,
   wherein the carboxylic acid is the formic acid, and
   in the (b), a temperature of the substrate support is 120°C or higher, and the pressure or the partial pressure of the carboxylic acid is 40 Pa or more.
[E12] The method for processing a substrate according to E8,
   wherein the carboxylic acid is the trifluoroacetic acid, and
   in the (b), a temperature of the substrate support is 90°C or higher, and the pressure or the partial pressure of the carboxylic acid is 40 Pa or more.
[E13] The method for processing a substrate according to E8,
   wherein the carboxylic acid is the acetic acid, and
   in the (b), a temperature of the substrate support is 120°C or higher, and the pressure or the partial pressure of the carboxylic acid is 40 Pa or more.
[E14] The method for processing a substrate according to any one of E1 to E13,
   wherein the (b) includes
      (b-1) performing dry development on the resist film under a first condition, and
      (b-2) performing dry development on the resist film under a second condition different from the first condition,
   a combination of the first condition and the second condition satisfies one or more of a condition (A), a condition (B), and a condition (C),
   the condition (A) includes developing the resist in the (b-1) using a first processing gas and developing the resist film in the (b-2) using a second processing gas different from the first processing gas, and in the condition (A), at least one of the first processing gas and the second processing gas includes the carboxylic acid,
   the condition (B) includes developing the resist film in the (b-1) by setting the pressure of the carboxylic acid to a first pressure and developing the resist film in the (b-2) by setting the pressure of the carboxylic acid to a second pressure different from the first pressure, and
   the condition (C) includes developing the resist film in the (b-1) by setting the substrate support to a first temperature and developing the resist film in the (b-2) by setting the substrate support to a second temperature different from the first temperature.
[E15] The method for processing a substrate according to any one of E1 to E13,
   wherein a period during which the (b) is performed includes a first period and a second period alternating with the first period,
   a combination of a processing condition for the first period and a processing condition for the second period satisfies one or more of a condition (A), a condition (B), and a condition (C),
   the condition (A) includes developing the resist film in the first period using a first processing gas and developing the resist film in the second period using a second processing gas different from the first processing gas, and in the condition (A), at least one of the first processing gas and the second processing gas includes the carboxylic acid,
   the condition (B) includes developing the resist film in the first period by setting the pressure of the carboxylic acid to a first pressure and developing the resist film in the second period by setting the pressure of the carboxylic acid to a second pressure different from the first pressure, and
   the condition (C) includes developing the resist film in the first period by setting a temperature of the substrate support to a first temperature and developing the resist film in the second period by setting the temperature of the substrate support to a second temperature different from the first temperature.
[E16] The method for processing a substrate according to any one of E1 to E13,
   wherein the second region is partially removed in the (b), and
   the method for processing a substrate further includes:
      after the (b), forming a deposition film on the first region;
      removing a residue generated in the (b) while protecting the first region with the deposition film; and
      removing a remainder of the second region.
[E17] The method for processing a substrate according to E16,
   wherein the deposition film is a carbon-containing film or a silicon-containing film, and
   the residue is removed by plasma of a processing gas containing at least one selected from the group consisting of a helium-containing gas, a hydrogen-containing gas, a bromine-containing gas, and a chlorine-containing gas.
[E18] The method for processing a substrate according to any one of E1 to E13,
   wherein the second region is partially removed in the (b), and
   the method for processing a substrate further includes:
      after the (b), heating the substrate; and
      removing a remainder of the second region.
   In the embodiment of E18, the temperature of the substrate in the operation of heating the substrate may be 180°C or higher or 190°C or higher. In addition, in the embodiment of E18, the temperature of the substrate in the operation of heating the substrate may be 240°C or lower or 220°C or lower. In addition, in the embodiment of E18, the operation of heating the substrate and the operation of removing the remainder may be performed by using a single chamber, or may be performed by using two or more different chambers. That is, the chamber used in the operation of heating the substrate and the chamber used in the operation of removing the remainder may be the same chamber, that is, a single chamber, or may be different chambers.
[E19] A system for processing a substrate including:
   a processing chamber;
   a substrate support disposed in the processing chamber;
   a gas supply configured to supply a processing gas containing a carboxylic acid into the chamber;
   an exhaust mechanism connected to the processing chamber; and
   a controller,
   wherein the controller is configured to control the gas supply and the exhaust mechanism to supply the processing gas into the chamber and to adjust a pressure or a partial pressure of the carboxylic acid to 40 Pa or more and less than 13,332 Pa, for dry development of a resist film of a substrate placed on the substrate support.

From the foregoing description, it will be appreciated that various examples of the present disclosure have been described herein for purposes of illustration, and that various modifications may be made without departing from the scope and spirit of the present disclosure. Accordingly, the various examples disclosed herein are not intended to be limiting, with the true scope and spirit being indicated by the following claims.

### Reference Signs List

1: plasma processing apparatus
2: controller
10: plasma processing chamber
11: substrate support
20: gas supply
30: power source
100: heat treatment apparatus
102: processing chamber
120: stage heater
121: substrate support
141: gas nozzle
200: controller
OP: opening
RM: resist film
RM1: first region
RM2: second region
UF: underlying film
W: substrate

## Claims

1. A method for processing a substrate comprising:
(a) providing a substrate on a substrate support in a processing chamber, the substrate having an underlying film and a resist film disposed on the underlying film and formed of a metal-containing resist, and the resist film having a first region and a second region; and
(b) dry-developing the resist film by supplying a processing gas containing a carboxylic acid into the processing chamber, exposing the substrate to the carboxylic acid, and selectively removing the second region with respect to the first region,
wherein in the (b), a pressure or a partial pressure of the carboxylic acid is 40 Pa or more and less than 13,332 Pa.

2. The method for processing a substrate according to Claim 1,
wherein in the (b), the pressure or the partial pressure of the carboxylic acid is 133 Pa or more.

3. The method for processing a substrate according to Claim 1,
wherein in the (b), the pressure or the partial pressure of the carboxylic acid is 666 Pa or more.

4. The method for processing a substrate according to Claim 1,
wherein in the (b), the pressure or the partial pressure of the carboxylic acid is 1,333 Pa or less.

5. The method for processing a substrate according to Claim 1,
wherein the processing gas contains an inert gas, and in the (b), the partial pressure of the carboxylic acid is 40 Pa or more.

6. The method for processing a substrate according to Claim 5,
wherein the partial pressure of the carboxylic acid is 8,000 Pa or less.

7. The method for processing a substrate according to Claim 1,
wherein in the (b), a temperature of the substrate support is 90°C or higher.

8. The method for processing a substrate according to Claim 1,
wherein in the (b), a temperature of the substrate support is 120°C or higher.

9. The method for processing a substrate according to Claim 1,
wherein in the (b), a temperature of the substrate support is 300°C or lower.

10. The method for processing a substrate according to Claim 1,
wherein the carboxylic acid is at least one selected from the group consisting of formic acid, trifluoroacetic acid, and acetic acid.

11. The method for processing a substrate according to Claim 10,
wherein the carboxylic acid is the formic acid, and
in the (b), a temperature of the substrate support is 120°C or higher, and the pressure or the partial pressure of the carboxylic acid is 40 Pa or more.

12. The method for processing a substrate according to Claim 10,
wherein the carboxylic acid is the trifluoroacetic acid, and
in the (b), a temperature of the substrate support is 90°C or higher, and the pressure or the partial pressure of the carboxylic acid is 40 Pa or more.

13. The method for processing a substrate according to Claim 10,
wherein the carboxylic acid is the acetic acid, and
in the (b), a temperature of the substrate support is 120°C or higher, and the pressure or the partial pressure of the carboxylic acid is 40 Pa or more.

14. The method for processing a substrate according to any one of Claims 1 to 13,
wherein the (b) includes
(b-1) performing dry development on the resist film under a first condition, and
(b-2) performing dry development on the resist film under a second condition different from the first condition,
a combination of the first condition and the second condition satisfies one or more of a condition (A), a condition (B), and a condition (C),
the condition (A) includes developing the resist in the (b-1) using a first processing gas and developing the resist film in the (b-2) using a second processing gas different from the first processing gas, and in the condition (A), at least one of the first processing gas and the second processing gas includes the carboxylic acid,
the condition (B) includes developing the resist film in the (b-1) by setting the pressure of the carboxylic acid to a first pressure and developing the resist film in the (b-2) by setting the pressure of the carboxylic acid to a second pressure different from the first pressure, and
the condition (C) includes developing the resist film in the (b-1) by setting the substrate support to a first temperature and developing the resist film in the (b-2) by setting the substrate support to a second temperature different from the first temperature.

15. The method for processing a substrate according to any one of Claims 1 to 13,
wherein a period during which the (b) is performed includes a first period and a second period alternating with the first period,
a combination of a processing condition for the first period and a processing condition for the second period satisfies one or more of a condition (A), a condition (B), and a condition (C),
the condition (A) includes developing the resist film in the first period using a first processing gas and developing the resist film in the second period using a second processing gas different from the first processing gas, and in the condition (A), at least one of the first processing gas and the second processing gas includes the carboxylic acid,
the condition (B) includes developing the resist film in the first period by setting the pressure of the carboxylic acid to a first pressure and developing the resist film in the second period by setting the pressure of the carboxylic acid to a second pressure different from the first pressure, and
the condition (C) includes developing the resist film in the first period by setting a temperature of the substrate support to a first temperature and developing the resist film in the second period by setting the temperature of the substrate support to a second temperature different from the first temperature.

16. The method for processing a substrate according to any one of Claims 1 to 13,
wherein the second region is partially removed in the (b), and
the method for processing a substrate further comprises:
after the (b), forming a deposition film on the first region;
removing a residue generated in the (b) while protecting the first region with the deposition film; and
removing a remainder of the second region.

17. The method for processing a substrate according to Claim 16,
wherein the deposition film is a carbon-containing film or a silicon-containing film, and
the residue is removed by plasma of a processing gas containing at least one selected from the group consisting of a helium-containing gas, a hydrogen-containing gas, a bromine-containing gas, and a chlorine-containing gas.

18. The method for processing a substrate according to any one of Claims 1 to 13,
wherein the second region is partially removed in the (b), and
the method for processing a substrate further comprises:
after the (b), heating the substrate; and
removing a remainder of the second region.

19. A system for processing a substrate comprising:
a processing chamber;
a substrate support disposed in the processing chamber;
a gas supply configured to supply a processing gas containing a carboxylic acid into the chamber;
an exhaust mechanism connected to the processing chamber; and
a controller,
wherein the controller is configured to control the gas supply and the exhaust mechanism to supply the processing gas into the chamber and to adjust a pressure or a partial pressure of the carboxylic acid to 40 Pa or more and less than 13,332 Pa, for dry development of a resist film of a substrate placed on the substrate support.
